(19) Europäisches Patentamt / European Patent Office / Office européen des brevets

(11) **EP 3 867 191 B1**

## (12) EUROPÄISCHE PATENTSCHRIFT

(45) Veröffentlichungstag und Bekanntmachung des Hinweises auf die Patenterteilung:
**17.07.2024 Patentblatt 2024/29**

(21) Anmeldenummer: **18789592.5**

(22) Anmeldetag: **16.10.2018**

(51) Internationale Patentklassifikation (IPC):
*B81B 3/00* (2006.01)      *H02N 1/00* (2006.01)

(52) Gemeinsame Patentklassifikation (CPC):
**B81B 3/0043; H02N 1/006**

(86) Internationale Anmeldenummer:
**PCT/EP2018/078298**

(87) Internationale Veröffentlichungsnummer:
**WO 2020/078541 (23.04.2020 Gazette 2020/17)**

(54) **BIEGEWANDLER ALS AKTOR, BIEGEWANDLER ALS SENSOR, BIEGEWANDLERSYSTEM**

BENDING TRANSDUCER AS AN ACTUATOR, BENDING TRANSDUCER AS A SENSOR, BENDING TRANSDUCER SYSTEM

TRANSDUCTEUR DE FLEXION COMME ACTIONNEUR, TRANSDUCTEUR DE FLEXION COMME CAPTEUR, SYSTÈME DE TRANSDUCTEUR DE FLEXION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**25.08.2021 Patentblatt 2021/34**

(73) Patentinhaber: **Fraunhofer-Gesellschaft zur Förderung der angewandten Forschung e.V. 80686 München (DE)**

(72) Erfinder:
• **SCHENK, Hermann**
  **01309 Dresden (DE)**
• **KAISER, Bert**
  **01689 Weinböhla (DE)**
• **EHRIG, Lutz**
  **01277 Dresden (DE)**

(74) Vertreter: **König, Andreas Rudolf et al Schoppe, Zimmermann, Stöckeler Zinkler, Schenk & Partner mbB Patentanwälte Radlkoferstraße 2 81373 München (DE)**

(56) Entgegenhaltungen:
**WO-A1-2012/095185     FR-A1- 2 376 549**

**Beschreibung**

Die vorliegende Erfindung bezieht sich auf einen Biegewandler und dessen Verwendung als Aktor oder Sensor und ein Biegewandlersystem.

Mikromechanische Bauelemente (MEMS) werden benötigt, um elektrische Signale in eine mechanische Wirkung, nämlich in dem Fall von Aktoren, oder um eine mechanische Einwirkung in ein elektrisches Signal umzuformen, nämlich in dem Fall von Sensoren. Wirkung meint im Sinne dieser Anmeldung, beispielsweise die Verrichtung von Arbeit und damit einher gehend eine Auslenkung oder Aufbringen von Biegemomenten.

An die Linearität des Zusammenhangs zwischen elektrischem Signal und mechanischer Wirkung (Übertragungscharakteristik) mikroelektromechanischer Bauelemente werden regelmäßig hohe Anforderungen gestellt. Das gilt beispielsweise für die Verwendung solcher mikroelektromechanischer Bauelemente für den Einsatz in Mikrofonen oder Lautsprechern. Nichtlinearitäten der Übertragungscharakteristik beeinflussen die Präzision, mit der mikroelektromechanischen Bauelemente ihre bestimmungsgemäße Funktion erfüllen können nachteilig und müssen mit aufwändigen Ansteuerungen in dem Fall von Aktoren oder mittels aufwändiger Signalverarbeitung in dem Fall von Sensoren korrigiert werden.

Beispielsweise führen Nichtlinearitäten in der Übertragungscharakteristik bei mikromechanischen Schallwandlern, d. h. Lautsprechern oder Mikrofonen, zu hohen Klirrfaktoren und müssen durch den zusätzlichen Einsatz von Mikroprozessoren bzw. Signalverarbeitung korrigiert werden.

Zusammenfassend gibt es also praktische Anwendungen, wie z. B. Mikrolautsprecher, bei denen ein linearer Zusammenhang zwischen der Höhe der angelegten Signalspannung und der Größe der von der Vorrichtung erzeugten mechanischen Wirkung, d. h. Arbeit zu verrichten, entscheidend ist. Gleichzeitig soll die spektrale Zusammensetzung des Ausgangssignales (im Falle eines Lautsprechers der Luftschall) identisch mit der spektralen Zusammensetzung des Eingangssignales sein, was einem geringen Klirrfaktor entspricht. Der Linearitätsbereich ist abhängigkeit von der Amplitude und der Frequenz und soll möglichst groß sein. Dazu ist es erforderlich die Sensitivität und die Frequenz durch Änderung der (elektrischen) Betriebsparameter zu variieren, ohne dabei die Lineariät wesentlich zu verändern. Sensitivät meint im Sinne dieser Anmeldung den Zusammenhang zwischen Wirkungsänderung gegenüber einer Signalveränderung.Bisherige konstruktive Realisierungen von MEMS-Bauelementen mit verbesserter Linearität der Übertragungscharakteristik basieren auf MEMS-Technologien mit unvorteilhaft hohem Spannungsbedarf bei konstruktiv begrenztem Dynamikbereich (bezüglich der Pull-in-Instabilität) und damit einem begrenzten Frequenzbereich , die für mobile Anwendungen ungeeignet sind.Beispielhaft dazu sei auf das Dokument US 97 834 08 B2 verwiesen.

In der WO 2095185 A1 wird zwar ausgeführt, wie MEMS-Bauelemente zu konstruieren sind, die eine große Leistungsfähigkeit bei geringer Leistungsaufnahme aufweisen, aber mögliche Maßnahmen zur Verbesserung und Einstellbarkeit der Linearität werden dort nicht beschrieben. Zum Zwecke der Erhöhung des Biegeradius oder zur Erhöhung der Antriebseffizienz bei gleichen Biegecharakteristika ist ein Biegewandlersystem aus zwei, von einer neutralen Faser beabstandeten Biegewandlern in der DE 10 2015 206 774 A1 vorgeschlagen. Der dabei ausgebildete Hohlraum soll lediglich die Biegeeinschaften positiv beeinflussen. Maßnahmen zur Verbesserung und Einstellbarkeit der Linearität werden nicht offenbart.

In FR 2 376 549 A1 wird ein Drei-Elektroden-System beschrieben, bei dem die Bewegung des beweglichen Ankers durch Vorspannungen erreicht wird, die an die festen Elektroden angelegt werden, sofern eine Steuerspannung zwischen der beweglichen Elektrode und der einen der festen Elektroden angelegt werden kann haben die von den Elektreten erzeugten elektrostatischen Haltekräfte aufgehoben.

Die Aufgabe der vorliegenden Erfindung besteht deshalb darin, einen Biegewandler und dessen Verwendung als Aktor oder Sensor und ein System aus solchen Biegewandlern zu schaffen, die bei gleicher oder vergleichbarer Leistungsfähigkeit eine verbesserte und einstellbare Linearität aufweisen.

Diese Aufgabe wird durch den Gegenstand der unabhängigen Patentansprüche gelöst.

Ein Kerngedanke der vorliegenden Anmeldung besteht darin, dass ein Biegewandler, der als Aktor verwendet wird, mit einer verbesserten und einstellbaren Linearität bei vergleichbarer Leistungsfähigkeit ausgestattet werden kann, wenn der Biegewandler ein auslenkbares Element mit einem ersten sich entlang der Flächenschwerpunktfaser des auslenkbaren Elements erstreckenden mikroelektromechanischen Wandler (im folgenden kurz als MEMS-Wandler bezeichnet) und einem zweiten sich entlang der Flächenschwerpunktfaser erstreckenden MEMS-Wandler aufweist, wobei sich die Flächenschwerpunktfaser zumindest zwischen den distalen Berandungen bzw. einander abgewandten Seiten der MEMS-Wandler oder sogar zwischen den MEMS-Wandlern befindet und das auslenkbare Element bei Anlegen eines ersten bzw. zweiten elektrischen Signals an den ersten bzw. zweiten MEMS-Wandler in entgegengesetzte Richtungen ausgelenkt wird, und wenn dabei die Variation des ersten und zweiten elektrischen Signals abhängig von dem elektrischen Eingangssignal so durchgeführt wird, dass die Phasen des ersten und zweiten elektrischen Signals zueinander verschoben sind. Die Phasenverschiebung kann zwischen 0,001°-240°, beides einschließlich, oder sogar zwischen 60-200°, beides einschließlich, liegen oder 180° betragen. Diese Ausführungsform ermöglicht es, Vorteile in Bezug auf die Linearität, wie sie ansonsten bei Verwendung eines Drei-Elektroden-Prinzips mit symmetrischer Ansteuerung ermöglicht werden würden, zu erzielen, ohne dabei an Problemen bezüglich der Leistungsfähigkeit zu leiden. Erfindungsgemäß kann durch die Ansteuerung ein großer Linearitätsbereich bei hoher Dynamik, also einem großen Amplitudenbereich, in einem großen Frequenzbereich erzielt werden. Auf ähnliche Weise besteht ein Teil des Kerngedankens der vorliegenden Anmeldung darin, erkannt zu haben, dass ein Biegewandler, der als Sensor verwendet wird, mit einer verbesserten und einstellbaren Linearität bei vergleichbarer Leistungsfähigkeit erhalten werden kann, wenn der Biegewandler mit einem auslenkbaren Element ausgestattet wird, bei dem wieder die Flächenschwerpunktfaser des auslenkbaren Elements zwischen den abgewandten Seiten des ersten und zweiten MEMS-Wandlers befindlich ist, und wenn die an den Anschlüssen der Wandler auf eine Verformung des auslenkbaren Elements hin ausgegebenen elektrischen Signale so verwendet werden, um ein Ausgangssignal zu erzeugen, dass eine Änderung des Ausgangssignals von einer Differenz einer Änderung des ersten elektrischen Signals an dem ersten Wandler und eine Änderung des zweiten elektrischen Signals an dem zweiten Wandler abhängt. Dabei kann zum einen eine Optimierung der Linearität bei Lastwechseln durchgeführt werden, zum anderen kann anwendungsspezifisch die Sensität und Selektivität (in diesem Fall die Resonanzfrequenz) angepasst werden um den linearen Dynamikbereich (in diesem Fall die Amplitude) und das lineare Frequenzband zu maximieren.

Gemäß Ausführungsbeispielen handelt es sich bei dem ersten und dem zweiten MEMS-Wandler jeweils um einen Plattenkondensator, der entlang einer Längsrichtung des auslenkbaren Elements und somit auch entlang der Flächenschwerpunktfaser in Segmente untergliedert ist, indem Elektroden des jeweiligen Plattenkondensators zwischen den Segmenten gegeneinander fixiert sind. Auf diese Weise kann die Auslenkung der Biegewandler groß gegenüber dem Abstand beider Elektroden sein. Die Flächenschwerpunktfaser kann sich zumindest zwischen einerander abgewandten Seiten der MEMS-Wandler, also abgewandten Seiten der distalen bzw. voneinander entfernt positionierten Elektroden der MEMS-Wandler oder sogar zwischen den distalen Elektroden der MEMS-Wandler oder zwischen einander abgewandten Seiten proximaler bzw. voneinander wenigstentfernten Elektroden der MEMS-Wandler oder sogar zwischen den MEMS-Wandlern, also zugewandten Seiten der proximalen Elektroden der MEMS-Wandler liegen. Bei manchen dieser Ausführungsbeispiele sind die Elektroden des jeweiligen Plattenkondensators in den Segmenten interdigital ausgeführt, so dass Vorsprünge der einen Elektrode in Zwischenräume zwischen entsprechenden Vorsprüngen der anderen Elektrode eintauchen, und umgekehrt. Dies erhöht die Leistungsfähigkeit bzw. die Sensitivität.

Bei den Ausführungsbeispielen, die den Biegewandler als Aktor verwenden, ist die elektrische Ansteuerung ausgebildet, um eine Kombination einer ersten Vorspannung und eines von dem Eingangssignal abhängigen ersten Signalanteils als das erste elektrische Signal an den ersten MEMS-Wandler und/oder eine Kombination einer zweiten Vorspannung und eines von dem Eingangssignal abhängigen zweiten Signalanteils als das zweite elektrische Signal an den zweiten MEMS-Wandler anzulegen. Die elektrischen Signale können z. B. elektrische Spannungen oder elektrische Ströme sein. Die Ansteuerung der MEMS-Wandler des Biegewandlers, der als Aktor verwendet wird, kann dabei aus zwei verketteten Netzwerkschleifen mit einer Vorspannung $U_0$ und einer variablen Signalspannung $U_{signal}$ bestehen. Dadurch ist die elektrische Ansteuerung ausgebildet, um die Änderung des ersten und des zweiten elektrischen Signals mit unterschiedlicher Amplitude durchzuführen, um eine asymmetrische Last auf das auslenkbare Element zu kompensieren. Die asymmetrische Last ist z. B. eine konstruktive Asymmetrie des mikroelektromechanischen Wandlers und/oder eine asymmetrische Kraft, die auf das auslenkbare Element wirkt, wie z. B. Druckunterschiede. Auf ähnliche Weise kann ein Biegewandler, der als Sensor verwendet wird, eine asymmetrische Last auf das auslenkbare Element kompensieren. Die Ansteuerung eines Biegewandlers, der als Sensor verwendet wird, kann ausgebildet sein, um an den ersten MEMS-Wandler und/oder an den zweiten MEMS-Wandler eine Vorspannung anzulegen. Gemäß Ausführungsbeispielen ist die Vorspannung oder sind die Vorspannungen der Biegewandler so eingestellt, dass die Flächenschwerpunktfaser des auslenkbaren Elements ohne externe mechanische Einflüsse auf das auslenkbare Element und im Fall eines Biegewandlers, der als Aktor verwendet wird, ohne von dem Eingangssignal abhängige Signalanteile nicht ausgelenkt ist.

Gemäß Ausführungsbeispielen wird somit der Biegewandler mit einer Ansteuerung versehen, die ausgelegt ist, um eine Vorspannung an den ersten und/oder an den zweiten MEMS-Wandler anzulegen, womit eine effektive bzw. wirksame Federsteifigkeit des Biegewandlers und/oder die Sensitivität des Biegewandlers und/oder die Resonanzfrequenz des Biegewandlers durch Einstellung der Vorspannung oder der Vorspannungen an dem ersten und/oder an dem zweiten MEMS-Wandler eingestellt werden kann. Die wirksame Federsteifigkeit des MEMS-Wandlers verändert sich gegenüber seiner mechanischen Federsteifigkeit mit der Höhe der Festspannung bzw. Vorspannung. Diese Ausführungsform ermöglicht es, die Linearität einstellen zu können.

Gemäß Ausführungsbeispielen weist die elektrische Ansteuerung des Biegewandlers, der als Aktor verwendet wird, eine Rückkopplungsschleife auf, um die Wirkung der asymmetrischen Last mittels einer geeigneten Rückkopplungsschleife mit Sensoren dynamisch, d. h. im Betrieb bei wechselnder Last, zu kompensieren. Alternativ können mittels aktiver Netzwerkkomponenten, wie z. B. Transistoren, Operationsverstärker etc. dabei die relevanten, elektrischen Netzwerkgrößen, wie z. B. Leistungsaufnahme, Impedanzen, Spannungen, Ströme, auf die jeweilige Lastsituation eingestellt werden. Insgesamt bedeutet das rückgekoppelte System eine dynamisch verbesserte Linearität der Übertragungscharakteristik.

Gemäß Ausführungsbeispielen weist ein Biegewandlersystem eine Mehrzahl von Biegewandlern auf, wobei die Biegewandler in Bezug auf die Dimensionierung der MEMS-Wandler übereinstimmen. In anderen Worten können die Biegewandler identisch ausgestaltet sein. Die effektive Federsteifigkeit und/oder die Resonanzfrequenz und/oder die Sensitivität der Biegewandler ist einzeln über die Vorspannung an den ersten und/oder zweiten MEMS-Wandler der Mehrzahl von Biegewandlern einstellbar. Ein Vorteil besteht dabei darin, dass die Resonanzfrequenzen bzw. das dynamische Verhalten unterhalb der Resonanzfrequenz in Abhängigkeit von einer Anwendungssituation über die Vorspannung einzeln eingestellt werden kann. Insgesamt lässt sich somit eine verbesserte Linearität erzielen, da jeder Biegewandler nur für ein bestimmtes Frequenzband zuständig ist und Abweichungen der Leistungsfähigkeit zwischen den Frequenzbändern durch Zuweisung unterschiedlicher Anzahlen von Biegewandlern zu den Frequenzbändern ausgleichbar sind. In anderen Worten ist es möglich, an sich gleich ausgestaltete Biegwandler durch die individuelle Vorspannungsansteuerung in unterschiedlichen Mengenanteilen den einzelnen Frequenzbändern zuzuordnen, für die sie dann empfindlich sind. Die Mengenanteile können ausgleichen, dass Biegewandler für ein Frequenzband empfindlich/wirksamer oder weniger empfindlich/wirksam sind als solche für ein anderes Frequenzband.

Manche Ausführungsbeispiele beziehen sich auf ein Biegewandlersystem mit einer Schaltung, die ausgebildet ist, um ein Gesamteingangssignal spektral auf eine Mehrzahl von Eingangssignalen für die Mehrzahl von Biegewandlern aufzuteilen oder aus einer Mehrzahl von Ausgangssignalen der Mehrzahl von Biegewandlern ein Gesamtausgangssignal spektral zusammenzustellen. Die Schaltung kann teilweise oder ganz ein Teil der Ansteuerung sein. Ein Aspekt der spektralen Aufteilung des Gesamteingangssignals oder spektraler Zusammenstellung des Ausgangssignals besteht darin, erkannt zu haben, dass sich die Linearität der mikroelektromechanischen Wandler durch Anordnungen mehrerer Biegewandler erhöhen lässt. Dabei kann die Anordnung so gestaltet sein, dass sich die Wirkungen der einzelne Biegewandler addieren, sodass der einzelne Biegewandler der Anordnung nur in einem Bruchteil des Dynamikbereichs (z. B. Auslenkung) betrieben werden. Dadurch wird die Linearität des Gesamtsystems verbessert.

Einige Ausführungsbeispiele beziehen sich auf einen Biegewandler, der ausgebildet ist, um entweder als Aktor oder als Sensor zu funktionieren und eine Schaltung, die ausgebildet ist, um den Biegewandler als Aktor oder als Sensor zu betreiben. Die Ausführungsformen sind platzsparend, da abhängig von den Anwendungsbereichen derselbe Biegewandler entweder als Sensor oder als Aktor verwendet werden kann.

Einige Ausführungsbeispiele beziehen sich auf ein Biegewandlersystem mit einer Vielzahl an Biegewandlern und eine Schaltung, die ausgebildet ist, um einen ersten Teil der Gesamtmenge der Biegewandler als Aktoren anzusteuern und einen zweiten Teil der Gesamtmenge der Biegewandler als Sensoren anzusteuern. Die Aufteilung in die beiden Teilmengen kann dabei statisch sein oder dynamisch abhängig von einem Steuersignal erfolgen. Ein Biegewandler kann in einem Zeitintervall sowohl als Aktor als auch als Sensor oder in einem ersten Zeitintervall als Sensor und in einem zweiten Zeitintervall als Aktor oder in einem ersten Zeitintervall als Aktor und in einem zweiten Zeitintervall als Sensor angesteuert werden. Die Anzahl der Sensoren bzw. der Aktoren ist über ein statisches oder ein dynamisches Steuerungssignal abhängig von dem Anwendungsbereich einstellbar.

Bevorzugte Ausführungsbeispiele der vorliegenden Anmeldung werden nachfolgend Bezug nehmend auf die Zeichnungen näher erläutert. Es zeigen:

Fig.1     ein Diagramm der Federkennlinie des verformbaren Elements der mikroelektromechanischen Bauelemente;
Fig.2     eine schematische Darstellung des Zwei-Elektroden-Prinzips;
Fig.3     ein Diagramm des Verhältnisses zwischen die Auslenkung und die Signalspannung eines Aktuators nach dem Zwei-Elektroden-Prinzip;
Fig.4a    eine schematische Darstellung einer Variante des Push-Pull-Prinzips;
Fig.4b    eine schematische Darstellung einer Variante des Push-Pull-Prinzips;
Fig.5     ein Diagramm der Zusammenhang zwischen elektrischer Signalstärke und mechanischer Verformung nach dem Drei-Elektroden-Prinzip.
Fig.6     eine schematische Darstellung eines verformbaren Elementes mit beidseitig angebrachten aktiven Schichten;
Fig.7a    ein Blockdiagramm eines symmetrischen Gesamtsystems und eine schematische Darstellung von einem Ausführungsbeispiel;
Fig.7b    ein Diagramm der Übertragungscharakteristik des in Fig. 7a gezeigten Ausführungsbeispiels;
Fig.8     eine schematische Darstellung des abstrakten Prinzips der Ansteuerung;
Fig.9     eine schematische Darstellung eines Biegewandlers als Aktor;
Fig.10    eine schematische Darstellung eines Biegewandlers als Sensor;
Fig.11    ein Blockdiagramm einer Lastanpassung;
Fig.12    ein Blockdiagramm einer dynamischen Lastanpassung;
Fig.13    eine schematische Darstellung eines Biegewandlersystems mit einer spektralen Aufteilungsschaltung;
Fig.14    eine schematische Darstellung eines Biegewandlersystems mit einer spektralen Zusammenstellungsschaltung;
Fig.15    eine schematische Darstellung eines Biegewandlersystems mit einer Vorspannungseinstellung;
Fig.16    eine schematische Darstellung eines Biegewandlers der als Aktor und/oder als Sensor betrieben werden kann mit einer Schaltung die ausgebildet ist, um den Biegewandler als Aktor und/oder als Sensor zu betrieben;

Fig.17 eine schematische Darstellung eines Biegewandlersystems mit einer Schaltung die ausgebildet ist, um den Biegewandler einzeln als Aktor und/oder als Sensor zu betrieben;

Fig.18a eine schematische Darstellung eines symmetrischen elektrostatisch in zwei Richtungen auslenkbaren und einseitig eingespannten Cantilevers - elektrische Vorspannung an der äußeren Elektroden;

Fig.18b eine schematische Darstellung eines symmetrischen elektrostatisch in zwei Richtungen auslenkbaren und einseitig eingespannten Cantilevers - elektrische Vorspannung der inneren Elektrode(n);

Fig.18c eine schematische Darstellung eines symmetrischen elektrostatisch in zwei Richtungen auslenkbaren und einseitig eingespannten Cantilevers - elektrische Vorspannung der inneren Elektrode(n);

Fig.18d eine schematische Darstellung eines symmetrischen elektrostatisch in zwei Richtungen auslenkbaren und einseitig eingespannten Cantilevers;

Fig.19a eine schematische Darstellung des Querschnittes eines elektrostatisch auslenkbaren und einseitig eingespannten Cantilevers mit inneren und äußeren Elektroden;

Fig.19b eine schematische Darstellung des Querschnittes eines elektrostatisch auslenkbaren und einseitig eingespannten Cantilevers mit verkippten Elektroden;

Fig.19c eine schematische Darstellung des Querschnittes eines elektrostatisch auslenkbaren und einseitig eingespannten Cantilevers mit kammförmigen Elektroden;

Fig.20a eine schematische Darstellung eines auslenkbaren Elementes, wobei nur ein halbes Segment gezeigt ist, und zwar mit mehrlagigem Elektrodenaufbau;

Fig.20b eine schematische Darstellung eines auslenkbaren Elementes, das zusätzlich zu Fig. 20a einen mittleren Hohlraum aufweist;;

Fig.20c eine schematische Darstellung eines auslenkbaren Elementes, bei dem gegenüber Fig. 20a die proximalen Elektroden planparallel und nicht konvex ausbauchend ausgeführt sind;

Fig.21a eine schematische Darstellung eines halben Segments mit Kammelektroden zur Erhöhung der deponierbaren elektrischen Feldenergie mit gegenüber Fig. 19c konvexer Segmentausgestaltung;

Fig.21b eine schematische Darstellung eines halben Segments mit Kammelektroden zur Erhöhung der deponierbaren elektrischen Feldenergie mit gegenüber Fig. 19c konkaver Segmentausgestaltung;

Fig.22 eine schematische Darstellung eines einseitig eingespannten auslankbaren Elemens mit gegenüber Fig. 19a asymmetrischer Ausgestaltung der beiden MEMS-Wandler.

Bevor nachfolgend Ausführungsbeispiele der vorliegenden Erfindung beschrieben werden, wird zunächst erläutert, welche Überlegungen die Erfinder zu selbigen führten. Im zuge dieser Ausführungen werden natürlich schon Hinweise auf Merkmale der nachfolgend beschriebenen Ausführungsbeispiele getätigt, die auch auf selbige übertragbar sein sollen.

Nichtlinearitäten mikroelektromechanischer Bauelemente haben ihren Ursprung sowohl in der elektromechanischen Konstruktion und ihres Wirkprinzips, sogenannte statische Nichtlinearitäten, als auch in dem dynamischen Verhalten der Bauelemente, sogenannte dynamische Nichtlinearitäten. Dynamische Nichtlinearitäten sind Folge mechanischer und/oder elektrischer Konstruktionsmerkmale. Dynamische Nichtlinearitäten, wie z. B. Intermodulation, Arbeitspunktsdrift, subharmonische Resonanzen, sind regelmäßig die Folge statischer Nichtlinearitäten. Die Korrektur vorhandener dynamische Nichtlinearitäten ist technisch aufwendig, sofern sie unter den gegebenen Umständen überhaupt praktisch möglich ist.

MEMS-Bauelemente der hier betrachteten Form besitzen mindestens ein verformbares Element. Die zur Verformung erforderliche Kraft lässt sich durch eine Federkennlinie charakterisieren. Ein strikt lineares Übertragungsverhalten setzt voraus, dass die entsprechende Federkennlinie am gewählten Arbeitspunkt im gesamten, gewählten Dynamikbereich strikt linear verläuft.

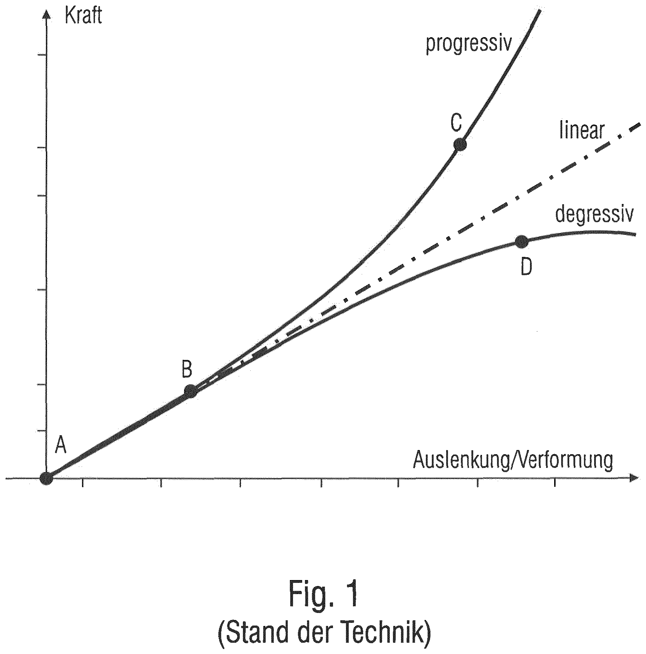

In Fig. 1 ist die Federkennlinie eines verformbaren Elements dargestellt. Handelt es sich bei den relevanten, verformbaren Elementen um Balken, Platten oder Plattensegmente, so ist der Verlauf der zugehörigen Federkennlinien für größere Auslenkungen nicht linear, sondern ganz oder teilweise progressiv oder degressiv. Alternativ kann auch eine Kombination auftreten. In einem ersten Zeitintervall degressiv, in einem zweiten Zeitintervall progressiv. Eine progressive oder degressive Federcharakteristik bewirkt regelmäßig eine nachteilhafte, nichtlineare Übertragungscharakteristik. Für den Betrieb eines MEMS-Bauelements kann an der entsprechenden Federkennlinie ein Arbeitspunkt, wie z. B. A, B, C oder D, gewählt werden, um den herum das verformbare Element seine Bewegung mit bestimmter maximaler Amplitude bzw. Dynamikbereich ausführt. Beispielsweise trifft das am Arbeitspunkt A für einen relativen großen Dynamikbereich zu. Bei Arbeitspunkt B ist der mögliche Dynamikbereich für einen linearen Betrieb durch das Einsetzen des progressiven bzw. degressiven Verlaufs der Federkennlinie beschränkt. Mit der Wahl des Arbeitspunkts C oder D erhält man ein MEMS-Bauelement hoher Sensitivität, d. h. die Federkennlinie verläuft hier besonders steil. Die Änderung dieses Anstieges hat hier ein höheres quantitatives Niveau und wirkt sich somit nachteilig auf den Dynamikbereich aus.

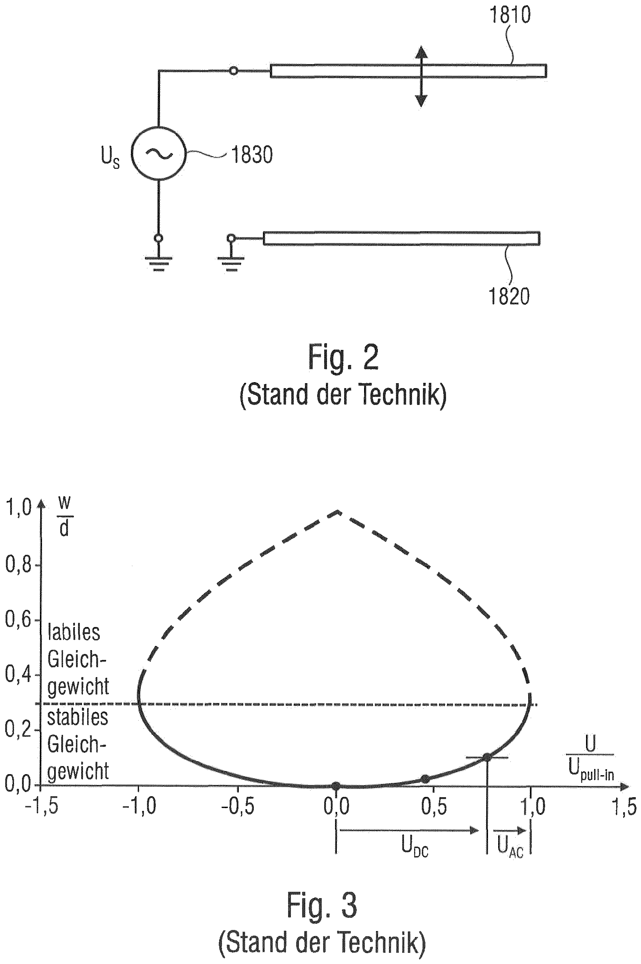

Fig. 2 zeigt einen MEMS-Bauelement nach dem Zwei-Elektroden-Prinzip. Kapazitiv arbeitende MEMS-Bauelemente nach dem Zwei-Elektroden-Prinzip enthalten mindestens ein verformbares oder bewegliches Element, einen sogenannten Translator oder Shutle 1810, welches als Elektrode ausgebildet und dessen Federkennlinie in Fig. 1 veranschaulicht ist, und eine weitere feststehende Gegenelektrode, den sogenannten Stator 1820. Bei dem Anlegen einer Spannung 1830, ziehen die zwischen den Elektroden entstehenden elektrostatischen Anziehungskräfte den Translator 1810 in Richtung auf den Stator 1820. Die Anziehung erfolgt unabhängig von dem Vorzeichen der angelegten Spannung 1830. Bei Nutzung als Sensor verändert das Bauelement bei mechanischer Einwirkung auf den Translator 1810 seine Kapazität. Die Kapazitätsänderung wird in diesem Fall zur Erzeugung eines Ausgangssignales genutzt.

In Fig. 3 ist der typische Zusammenhang zwischen elektrischer Signalstärke bzw. Spannung und mechanischer Verformung bzw. Auslenkung für ein MEMS-Bauelement nach dem Zwei-Elektroden-Prinzip, wie in Figur 2 veranschaulicht, dargestellt. Zum Betrieb eines kapazitiven MEMS-Bauelementes nach dem Zwei-Elektroden-Prinzip wird durch Anlegen einer Vorspannung $U_{DC}$ ein Arbeitspunkt gewählt (z. B. A, B oder C). Im Fall eines Biegewandlers, der als Aktor verwendet wird, kann dieser Vorspannung dann eine Signalspannung $U_{AC}$ überlagert werden. Im Fall eines Biegewandlers, der als Sensor verwendet wird, kann eine mechanische Einwirkung eine Bewegung bewirken und dabei eine entsprechende Signalspannung um den Arbeitspunkt erzeugen. Dabei sollte die absolute Summe von Vor- und Signalspannung den kritischen Spannungsbetrag, die sogenannte Pull-In-Spannung $U_{pull-in}$, nicht übersteigen. Dieser kritische Spannungswert wird dadurch definiert, dass bei Spannungen oberhalb dieser Grenze das zur bestimmungsgemäßen Funktion notwendige Kräftegleichgewicht mechanischer und elektrischer Kräfte labil und daher nicht relevant ist.

Der Arbeitspunkt A erfordert eine Vorspannung gleich Null. Die Federkennlinie, wie in Fig. 1 veranschaulicht, verläuft in diesem Arbeitspunkt zwar praktisch linear, allerdings erzeugt die Signalspannung unabhängig von ihrem Vorzeichen eine Bewegung in nur einer Richtung und bewirkt damit ein stark nichtlineares Übertragungsverhalten, wie z. B. eine Frequenzverdopplung oder eine dynamisch verursachte Verschiebung des Arbeitspunktes.

Der Arbeitspunkt B ermöglicht einen Richtungswechsel der Bewegung des verformbaren Elementes mit dem Wechsel des Vorzeichens der Signalspannung. Auch ermöglicht der Verlauf der zugehörigen Federkennlinie bei hinreichend klein gewählter Vorspannung ein lineares Übertragungsverhalten; allerdings ist die im linearen Betrieb maximal mögliche Auslenkung bzw. Dynamikbereich durch die geringe, maximal mögliche Auslenkung bei negativer Signalspannung sehr stark eingeschränkt.

Der Arbeitspunkt C ermöglicht einen Richtungswechsel der Bewegung des verformbaren Elementes mit dem Wechsel des Vorzeichens der Signalspannung und grundsätzlich einen großen Dynamikbereich. Allerdings verläuft in der Umgebung des Arbeitspunktes sowohl die zugehörigen Federkennlinie als auch Auslenkungs-Spannungs-Charakteristik stark nichtlinear.

Charakteristisch für das Zwei-Elektroden-Prinzip sind also konstruktionsbedingte Nichtlinearitäten. Das heißt, die von der Vorrichtung bestimmungsgemäß ausgeführte mechanische Bewegung folgt dem elektrischen Eingangssignal nicht proportional. Solche Nichtlinearitäten können im Wesentlichen durch Anlegen einer zeitlich konstanten Vorspannung als Arbeitspunkt in Verbindung mit einer nachteiligen Einschränkung der maximal zulässigen Amplitude der mechanischen Bewegung nur in engen Grenzen vermindert werden. Ein weiteres Problem ist, dass sich eine vorteilhafte Erhöhung der Sensitivität der Vorrichtung gegenüber der Variation des Eingangssignales mittels Erhöhung der konstanten elektrischen Vorspannung bzw. Arbeitspunkt nachteilhaft auf die Linearität auswirkt. Ein weiteres Problem genannter Vorrichtungen ist, dass die dort gegebene Nichtlinearität Oberschwingungen gerader Ordnung mit der Folge erzeugt, dass sich die geometrische Position des Nullpunktes einer von der Vorrichtung ggf. bestimmungsgemäß ausgeführten mechanischen Schwingung dynamisch verschiebt. Diese Fallunterscheidung trifft sinngemäß gleichermaßen auch bei Nutzung des kapazitiven MEMS-Bauelementes nach dem Zwei-Elektroden-Prinzip als Sensor zu.

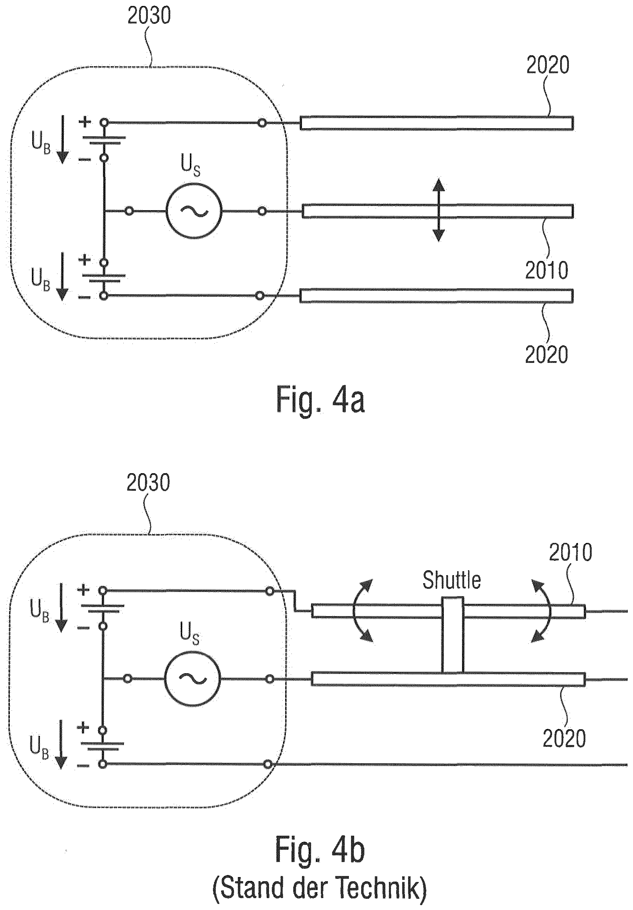

Daneben existieren kapazitiv arbeitende MEMS-Bauelemente nach dem Drei-Elektroden-Prinzip. In Figuren 4a und 4b sind MEMS-Bauelemente nach dem Drei-Elektroden-Prinzip bzw. Push-Pull-Prinzip mit mindestens einem beweglichen oder verformbaren Element bzw. Translator 2010 und einem feststehenden Element bzw. Stator 2020 dargestellt. Die Drei-Elektroden-Anordnung wird mittels einer festen Vorspannung $U_B$ und zusätzlich mit einer variablen Signalspannung $U_S$ betrieben. Dabei erlaubt die Elektrodenanordnung eine elektrische Ansteuerung 2030 dergestalt, dass der Translator 2010 gegenüber dem Stator 2020 durch die entstehenden, elektrostatischen Kräfte in zwei entgegengesetzte Richtungen ausgelenkt werden kann. Damit das möglich ist, sind Stator 2020 und Translator 2010 mit insgesamt mindestens drei Elektroden unterschiedlicher Funktion ausgestattet. Das Drei-Elektroden-Prinzip verbesserte durch die symmetrische Ausgestaltung bereits minimal das Linearitätsverhalten, aber mit Nachteilen, wie z.B. der Pull-In-Gefahr und Nachteilen in Bezug auf eine geringe Leistungsfähigkeit.

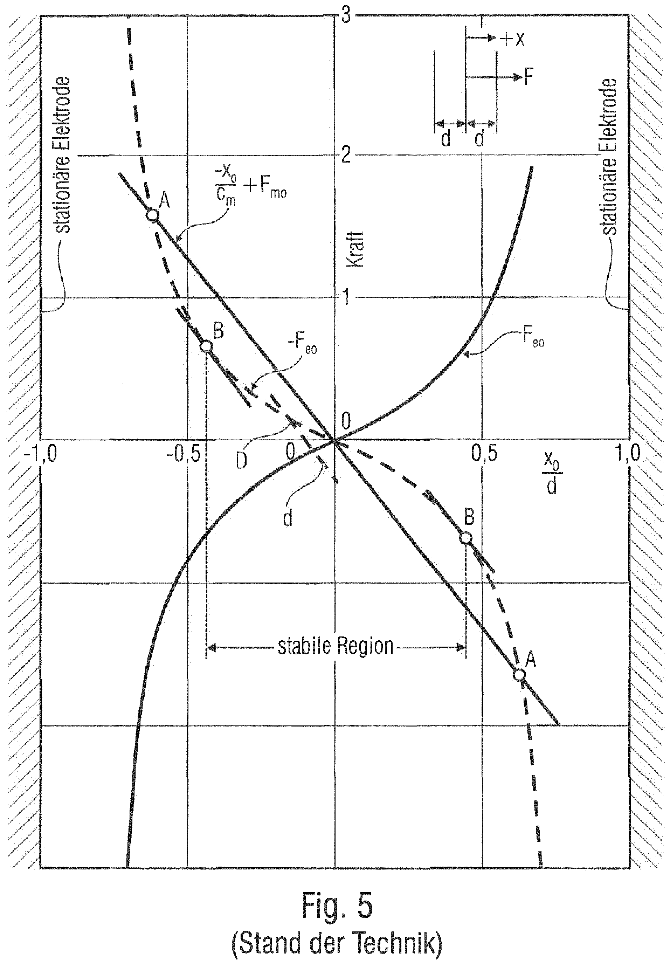

Fig. 5 zeigt den typischen Zusammenhang zwischen elektrischer Signalstärke bzw. Spannung und mechanischer Verformung bzw. Auslenkung für ein MEMS-Bauelement nach dem Drei-Elektroden-Prinzip, wie in Figuren 4a und 4b veranschaulicht, für den Fall der symmetrischen Ansteuerung. Bei symmetrischer Ansteuerung ist die Ruheposition des Translators, d.h. bei Signalspannung gleich Null, unabhängig von der elektrischen Vorspannung. Am Arbeitspunkt ist das verformbare Element mechanisch in Ruhelage, d.h. nicht verformt. Damit sind sowohl Federkennlinie, als auch die Charakteristik des Zusammenhangs zwischen Auslenkung und Signalspannung am Arbeitspunkt und für einen maximalen Dynamikbereich linear.

Im Folgenden wird nun anhand der schematischen Darstellungen der prinzipielle Aufbau eines Biegewandlers und Biegewandlersystems und deren prinzipielle Funktionsweise gemäß Ausführungsbeispielen dargestellt.

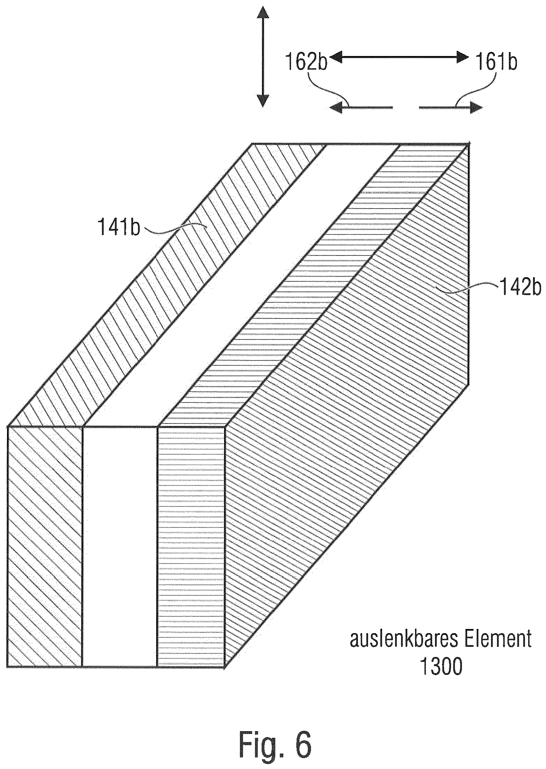

Fig. 6 zeigt eine schematische perspektivische Ansicht eines verformbaren bzw. auslenkbaren Elements 1300 mit beidseitig angebrachten aktiven Schichten bzw. MEMS-Wandlern 141b und 142b. Bei Anlegen eines ersten elektrischen Signals an den MEMS-Wandler 141b wird das auslenkbare Element 1300 in eine erste Richtung 161b ausgelenkt. In ähnlicher Weise wird bei Anlegen eines zweiten elektrischen Signals an den MEMS-Wandler 142b das auslenkbare Element 1300 in eine zweite zu der ersten entgegengesetzten Richtung 162b ausgelenkt.

Die verbesserte Linearität der Übertragungscharakteristik des auslenkbaren Elements kann durch eine symmetrische Gestaltung des verformbaren Elements 1300 und eine symmetrische Gestaltung und symmetrische Anordnung der Bimorph-Strukturen 141b,142b auf dem verformbaren Element 1300 im Zusammenspiel mit einer symmetrischen elektrischen Ansteuerung erreicht werden.

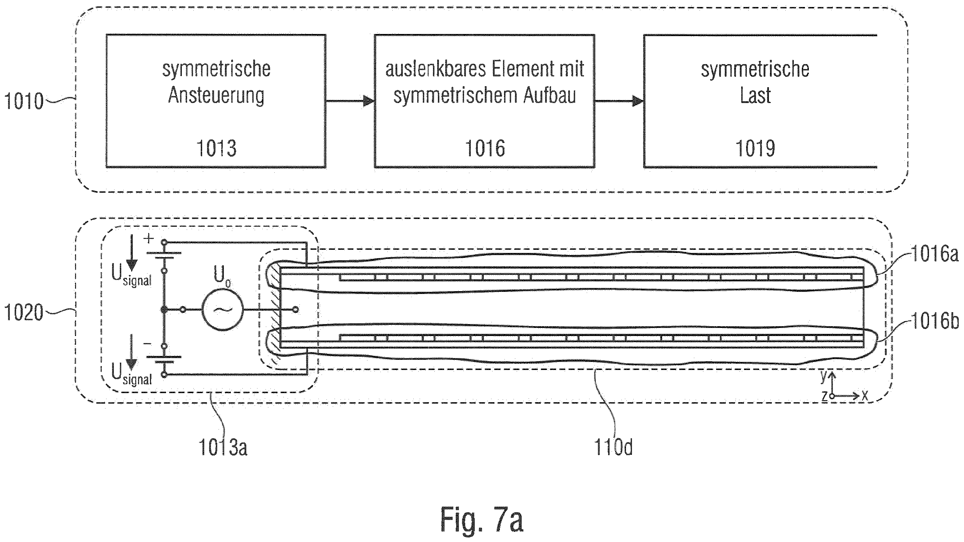

Ein entsprechendes Ausführungsbeispiel 1020 und ein Blockdiagramm 1010 für den Fall einer symmetrischen Last 1019 ist in Fig. 7a dargestellt. Das Blockdiagramm 1010 besteht aus den drei nachfolgenden Blöcke: symmetrische Ansteuerung 1013, symmetrischer MEMS-Wandler 1016 und symmetrische Last 1019. Das Ausführungsbeispiel 1020 veranschaulicht ein symmetrisches auslenkbares Element 110n mit symmetrischen MEMS-Wandlern 1016a, 1016b und eine symmetrische Ansteuerung 1013a, bestehend aus zwei verketteten Netzwerkschleifen. Die Symmetrie sollte so gestaltet sein, dass die Übertragungscharakteristik des Gesamtsystems, bestehend aus Ansteuerung, MEMS-Wandler und Last, dem Symmetrieprinzip genügt, d.h. sich bei Umkehrung des Vorzeichens der Signalspannung eine Auslenkung des verformbaren Elements im Wesentlichen der gleichen Höhe aber mit entgegengesetztem Vorzeichen ergibt.

Diese Symmetrie hat die Unterdrückung von mechanischen Oberschwingungen der geraden Ordnung zur Folge. Für die hier betrachteten, elektrostatischen Wandler ist außerdem die Amplitude der dritten harmonischen Oberschwingung stets kleiner als die Amplitude der zweiten harmonischen Oberschwingung. Damit reduziert die Symmetrie auch die Amplitude harmonischer Oberschwingungen dritter Ordnung. Insgesamt bedeutet das eine geringe harmonische Verzerrung (THD), also eine deutlich verbesserte Linearität.

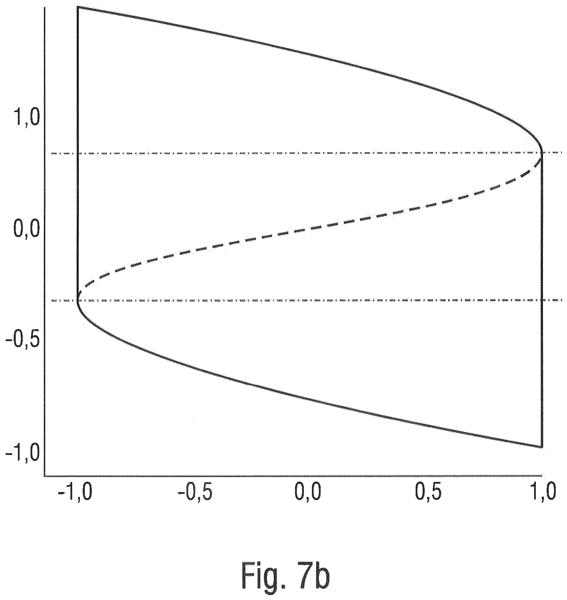

In Fig. 7b ist die Übertragungscharakteristik des in Fig 7a gezeigten Ausführungsbeispiels dargestellt. Für den praktischen Betrieb ist der gestrichelt dargestellte Ast der gezeigten Kurve relevant. Das Symmetrieprinzip wird durch dieses Ausführungsbeispiel demnach erfüllt.

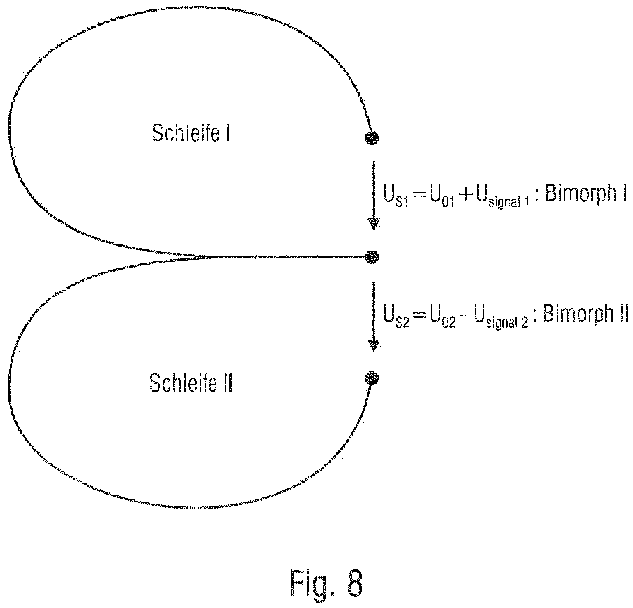

Die symmetrische Ansteuerung 1013a verwendet das in Fig. 8 vorgestellte abstrakte Prinzip. Die Ansteuerung 1013a in Fig. 7a ist in Fig. 8 als zwei Schleifen, Schleife I, Schleife II veranschaulicht. Schleife I ist an den ersten MEMS-Wandler 1016a bzw. Bimorph I gekoppelt und Schleife II ist an den zweiten MEMS-Wandler 1016b bzw. Bimorph II gekoppelt. Das erste bzw. zweite elektrische Signal der Schleife I bzw. der Schleife II weist eine verkettete Netzwerkschleife mit einer Vorspannung $U_{01}$ bzw. $U_{02}$ und einer Signalspannung $U_{signal1}$ bzw. $U_{signal2}$ auf. In dem Fall der Symmetrie sind die Vorspannungen $U_{01}$ und $U_{02}$ der Schleife I bzw. der Schleife II gleich und sind die Signalspannungen $U_{signal1}$ und $U_{signal2}$ der Schleife I bzw. der Schleife II betragsgleich, wirken aber mit entgegengesetzten Vorzeichen.

Nachfolgend beschriebene Ausführungsbeispiele nutzen die obigen Erkenntnisse und Überlegungen und sind in der Lage bei geringem Spannungsbedarf bzw. hoher Leistungsfähigkeit auch eine verbesserte Linearität der Übertragungscharakteristik zu besitzen.

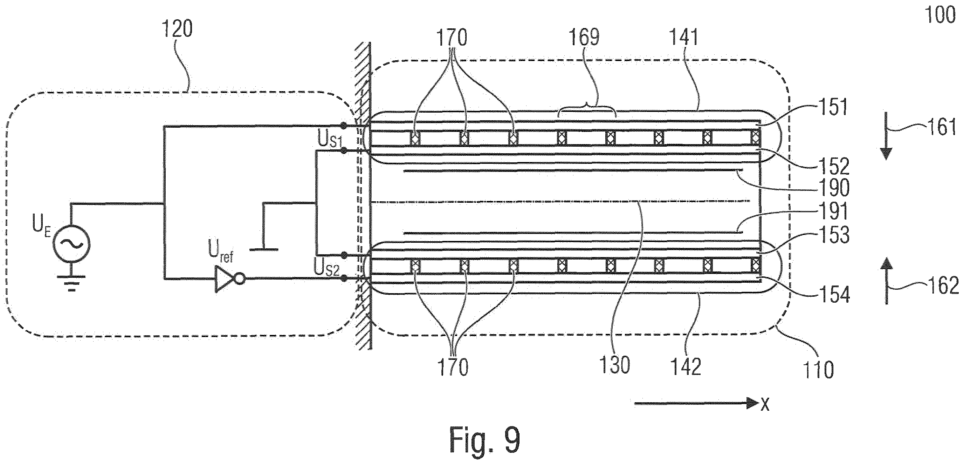

Fig. 9 zeigt einen als Aktor betriebenen Biegewandler. Er ist mit dem Abzugszeichen 100 angezeigt. Der Biegewandler 100 weist ein auslenkbares Element 110, wie es in Bezug auf Figur 6 näher veranschaulicht wurde, und eine elektrische Ansteuerung 120, die das in Fig. 8 vorgestellte Prinzip verwendet, auf. Das auslenkbare Element 110 weist einen ersten von einer Flächenschwerpunktfaser 130 des auslenkbaren Elements 110 beabstandeten und sich entlang derselben erstreckenden MEMS-Wandler 141 und einen zweiten von der Flächenschwerpunktfaser 130 beabstandeten und sich entlang derselben erstreckenden MEMS-Wandler 142 auf. Die Flächenschwerpunktfaser 130 definiert alle Punkte, an denen das auslenkbare Element 110 in Schnittebenen quer zur Längsrichtung x den Flächenschwerpunkt aufweist. Anders ausgedrückt definert die Flächenschwerpunktfaser einen Pfad in dem Bauteil, der aus einer Vielzahl an Punkten besteht bzw. diese verbindet, die sich aus Flächenschwerpunkten einer Vielzahl an aufeinanderfolgenden Querschnittsflächen des auslenkbaren Elements ergeben. Weiterhin sind exemplarisch mit 190 und 191 zwei von der Flächenschwerpunktfaser 130 in entgegengesetzte Richtungen beabstandete Fasern dargestellt. Bei Anlegen eines ersten elektrischen Signals, in dem Beispiel von Fig. 9 einer Spannung $U_{s1}$, an den MEMS-Wandler 141 das auslenkbare Element 110 in eine erste Richtung 161 ausgelenkt. In ähnlicher Weise wird bei Anlegen eines zweiten elektrischen Signals, hier ebenfalls als Spannung $U_{s2}$ veranschaulicht, an den MEMS-Wandler 142 das auslenkbare Element 110 in eine zweite zu der ersten entgegengesetzten Richtung 162 ausgelenkt. In anderen Worten ausgedrückt bewirkt der MEMS-Wandler 141 in dem Fall seiner Aktivierung durch Anlegen einer Spannung eine Auslenkung in Richtung 161 durch eine laterale Dehnung einer in Richtung 161 vor der Flächenschwerpunktfaser 130 gelegenen Faser 190 des Elements 110 bei gleichzeitiger Kontraktion einer in Richtung 161 hinter der Flächenschwerpunktfaser 130 gelegenen Faser 191. Dies geschieht durch den später noch beschriebenen Phasenversatz in der Ansteuerung in einem ersten Zeitintervall. In einem zweiten Zeitintervall bewirkt der andere der MEMS-Wandler, nämlich 142, durch seine Aktivierung durch Anlegen einer Spannung an ihn die Auslenkung des Elements 110 in Richtung 162 unter lateraler Dehnung der Faser 191 und Kontraktion der Faser 190. Hier ist exemplarisch der Fall einer Dehnung gezeigt, die auf das Anlegen des entsprechenden Signals hin an den jeweiligen MEMS-Wandler 141/142 eintritt, aber der andere Fall ist ebenfalls denkbar. Gemäß Ausführungsbeispielen der vorliegenden Anmeldung sind erste und der zweite MEMS-Wandler 141, 142 wie in Fig. 9 veranschaulicht jeweils als einen entlang einer Längsrichtung x des auslenkbaren Elements 130 segmentierter Plattenkondensator ausgebildet. Die Elektroden 151 bis 154 des jeweiligen Plattenkondensators 141, 142 sind zwischen den Segmenten 169 an den Segmentgrenzen 170 isoliert gegeneinander fixiert.

Dazu kann jeweils eine zwischen den Elektroden 151 bis 154 des jeweiligen Plattenkondensators 141, 142 befindliche Abstandhalterschicht vorgesehen und entsprechend lateral strukturiert sein, um an den Segmentgrenzen 170 Abstandshalter auszubilden, die die Elektroden des jeweiligen MEMS-Wandlers gegeneinander fixieren. Bei Anlegen einer Spannung zwischen Elektroden 151 und 152 bzw. zwischen 153 und 154 ergibt sich eine Dehnung oder alternativ bei bestimmter Gestaltung der Segmente eine Kontraktion und dadurch die beschrieben Auslenkung. Weitere Details hierzu können der WO2012095185 entnommen werden.

Die elektrische Ansteuerung 120 ist ausgebildet, um das erste elektrische Signal $U_{s1}$ und das zweite elektrische Signal $U_{s2}$ abhängig von einem Eingangssignal $U_E$ zu variieren, so dass eine Änderung des ersten elektrischen Signals $U_{s1}$ und eine Änderung des zweiten elektrischen Signals $U_{s2}$ abhängig von dem elektrischen Eingangssignal $U_E$ ist, und die Phasen des ersten und zweiten elektrischen Signals $U_{s1}$, $U_{s2}$ zueinander verschoben sind, wie zum beispiel gegenphasig um 180° oder phasenverschoeben um einen Phasenversatz zwischen 0,001°-240°, beides einschließlich, oder zwischen 60°-200°.

Durch die Möglichkeit einer symmetrischen Gestaltung des verformbaren Elements 110, so dass beispielsweise die Flächenschwerpunktfaser 130 eine Symmetrieebene desselben bildet, und eine symmetrische Ansteuerung, wie es in Bezug auf Figur 7a veranschaulicht wurde, im Zusammenspiel mit einer symmetrischen elektrischen Ansteuerung ist es möglich eine hohe Leistungsfähigkeitbei gleichzeitig hoher Linearität zu erzielen. Nachfolgend werden noch Maßnahmen beschrieben, die die Erreichung dieses Ziels noch verbessern.

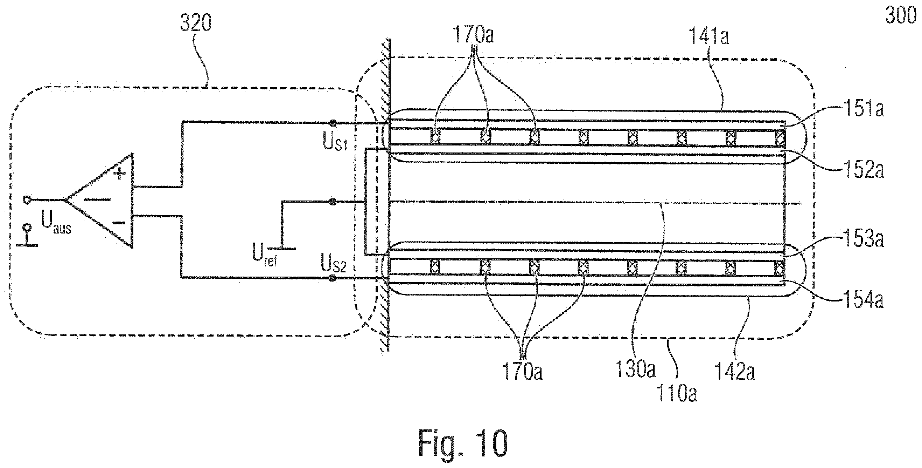

In Fig. 10 ist ein als Sensor betriebener Biegewandler 300 mit einem auslenkbaren Element 110a, wie es in Bezug auf Figur 6 näher veranschaulicht wurde, und einer elektrischen Schaltung 320, die das in Fig. 8 vorgestellte Prinzip verwendet, dargestellt. Das auslenkbare Element 110a des Biegewandlers 300 kann wie das auslenkbare Element 110 des Biegewandlers 100 in Figur 9, der als Aktor verwendet wird, aufgebaut sein, weshalb auf die Beschreibung aus Fig 9 verwiesen und die Bezugszeichen übernommen wurden. Eine Verformung des auslenkbaren Elements 110a kann anhand eines ersten bzw. zweiten elektrischen Signals, hier wieder als Spannungen $U_{s1}$, $U_{s2}$ veranschaulicht, an dem ersten bzw. zweiten MEMS-Wandlers 141a, 142a ermittelt werden. In dem Fall der Ausgestaltung der MEMS-Wandler 141a,142a als segmentierte Plattenkondensatoren entstehen die Signale beispielsweise als Spannungen an den Elektroden derselben. Die elektrische Schaltung 320 ist ausgebildet, um aus dem ersten elektrischen Signal $U_{s1}$ und dem zweiten elektrischen Signal $U_{s2}$ ein Ausgangssignal $U_{aus}$ zu erzeugen, so dass eine Änderung des Ausgangssignals $U_{aus}$ von einer Differenz einer Änderung des ersten elektrischen Signals und eine Änderung des zweiten elektrischen Signals $U_{s1}$, $U_{s2}$ abhängt. Wie auch bei Fig. 9 wird durch die Möglichkeit einer symmetrischen Gestaltung des verformbaren Elements 110, so dass beispielsweise die Flächenschwerpunktfaser 130 eine Symmetrieebene desselben bildet, und einer symmetrischen elektrischen Vorschaltung 1013a, wie sie in Bezug auf Figur 7a veranschaulicht wurde, eine hoher Leistungsfähigkeit bei gleichzeitig hoher Linearität ermöglicht. Nachfolgend werden noch Maßnahmen beschrieben, die das Erreichen dieses Ziels auch in dem vorliegenden Fall des Betreibens des Biegewandlers als Sensor verbessern.

Ohne dass darauf in der nachfolgenden Beschreibung gesondert daraf hingewiesen wird, sei erwähnt, das es sich bei den auslenkabren Elementen 110 bzw. 110a um einseitig eingespannte Elemente, wie z.B: einseitig eingespannte Balken handeln kann, mit der Einspannung an einem Ende des auslankbaren Elements entlang der vorerwähnten Segmentierungsrichtung x. In den Figuren ist die Einspannung manchmal links mit einer Schraffur angedeutet.

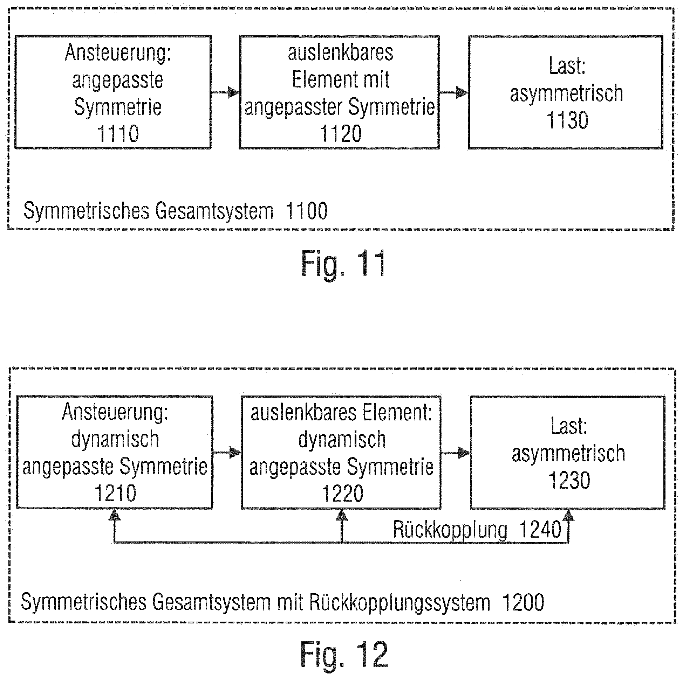

Bei bestimmungsgemäßem Einsatz sind die verformbaren Elemente 110, 110a eines Biegewandlers externen Kräften bzw. einer externen Last ausgesetzt, die selbst asymmetrisch in Bezug auf die Bewegungsrichtung der verformbaren Elemente sein können, wie z. B. durch das Eigengewicht oder in dem Fall einer Kolbenbewegung in einer Mikropumpe. Fig. 11 zeigt ein Blockdiagramm eines symmetrischen Gesamtsystems 1100 mit einer asymmetrischen Last 1130. Das Blockdiagramm des symmetrischen Gesamtsystems 1100 weist drei nachfolgende Blöcke auf: Ansteuerung mit angepasster Symmetrie 1110, verformbares Element mit angepasster Symmetrie 1120, asymmetrische Last 1130.

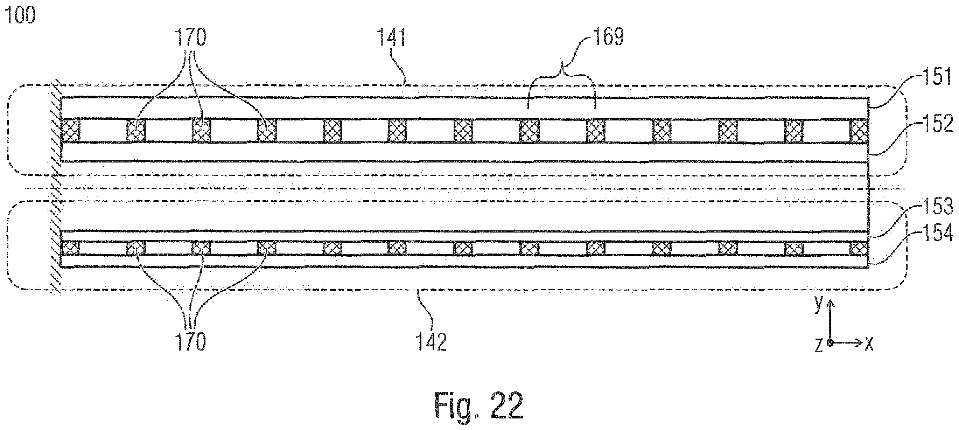

Die notwendige Symmetrie des Gesamtsystems aus Ansteuerung 120, verformbaren Element 110,110a, offenbart in Fig. 9, und Last kann durch gezielte Anpassung der Wandler-Gestaltung und/oder Anpassung seiner elektrischen Ansteuerung an die asymmetrische Last 1130 erreicht werden. Die Symmetrie der einzelnen Teile des Gesamtsystems, wie es in Fig 7a angedeutet ist, ist nicht notwendig. Die Symmetrie des Biegewandlers kann durch eine an die asymmetrische Last 1130 (Fig. 11) angepasste asymmetrische Bimorph-Struktur des Biegewandlers erreicht werden, also eine Symmetrie des Elements 110, 110a in Fig 9 und 10 beispielsweise. Die Symmetrieanpassung der Bimorph-Struktur 141,141a,142,142a kann unter anderem durch Variation der Elektrodendicke oder des Elektrodenabstandes dies und jenseits der Symmetrielinie des verformbaren Elements 110,110a erfolgen. Ein Beispiel dazu ist in Fig. 22 offenbart. Die Symmetrieanpassung kann aber auch durch eine Anpassung der Ansteuerung 120 bzw. der Schaltung 320 (Fig. 10), beispielsweise durch Einführung kompensierender, elektrischer Impedanzen in Schleife I oder in Schleife II erfolgen bzw. entsprechende den MEMS-Wandler 141,141a,142,142a zugeordnete Teil der Ansteuerung. Schließlich verändert sich die wirksame Federsteifigkeit k' des verformbaren Elementes 110,110a gegenüber seiner mechanischen Federsteifigkeit k mit der Höhe der Festspannung $U_0$.

$$k' = k \left( 1 - \left( \frac{U_0}{U_{max}} \right)^2 \right)$$

Daher kann die Anpassung des Systems an eine asymmetrische Last 1130 auch durch Wahl unterschiedlicher Festspannungen $U_{01}$ und $U_{02}$ in Schleife I und in Schleife II erfolgen, also durch Anlegen unterschiedlicher Vorspannungen an die MEMS-Wandlereinheit 141 und 142 durch die Ansteuerung 120 in dem Fall von Figur 9 bzw. das Vorsehen unterschiedlicher Vorspannungen durch die elektrische Schaltung 320 in dem Fall von Fig. 10. Die Maßnahmen zur Symmetrieanpassung auf der Ebene von Ansteuerung und auslenkbarem Element 110,110a können so ausgelegt werden, dass das Symmetrieprinzip für das Gesamtsystem innerhalb praktisch relevanter Grenzen erfüllt wird.

Noch einmal in anderen Worten ausgedrückt, können in den Fig. 9 und 10 die elektrische Schaltung 320 bzw. die Ansteuerung 120 derart ausgestaltet sein, dass sie zur Kompensation einer asymmerischen Last auf das auslenkbare Element 110/110a, das beispielsweise aus dem Einsatz herrührt und beispielsweise konstant ist, den MEMS-Wandler 141/141a und/oder den MEMS-Wandler 142/142a mit einer Vorspannung betreiben, die sich zwischen denselben unterscheidet, um die Asymmetrie der Belastung auszugleichen. Bewirkt die asymmetrische Last beispielsweise eine Auslenkung des auslenkbaren Elements im Ruhezustand in der Richtung 162 wird beispielsweise derjenige MEMS-Wandler mit einer höheren Vorspannung betrieben, der eine Auslenkung in die entgegengesetzte Richtung bewirkt.

Die Anpassung der Wandler-Symmetrie und/oder Anpassung seiner elektrischen Ansteuerung 120 bzw. der Schaltung 320 an eine asymmetrische Last 1130 kann mittels geeigneter Sensoren und einem Rückkopplungssystem, im Gegensatz zu Figur 11, auch dynamisch, das heißt im Betrieb bei wechselnder Last, erreicht werden. Mittels aktiver Netzwerkkomponenten, wie z. B. Transistoren, Operationsverstärker, etc. werden dabei die relevanten, elektrischen Netzwerkgrößen, wie z. B. Impedanzen, Spannungen, Ströme, auf die jeweilige Lastsituation eingestellt. Fig. 12 zeigt ein Blockdiagramm des symmetrischen Gesamtsystems mit einem Rückkopplungssystem 1200. Das Blockdiagramm weist drei nachfolgende Blöcke und eine Rückkopplung 1240 auf. Die drei Blöcke sind: eine Ansteuerung mit dynamisch angepasster Symmetrie 1210, ein verformbares Element mit dynamisch angepasster Symmetrie 1220, und eine asymmetrische Last 1230. Die Rückkopplung 1240 verknüpft die asymmetrische Last 1230 mit dem verformbaren Element 1220 und mit der Ansteuerung 1210.

In anderen Worten ausgedrückt, kann es sein, dass die asymmetrische Last auf das auslenkbare Element 110/110a in den Fig. 9 und 10 gemessen wird. Die Messung kann extern stattfinden und der Ansteuerung 120 bzw. der elektrischen Schaltung 320 zugeführt werden, damit letztere die Vorspannung für den MEMS-Wandler 141/141a und/oder den MEMS-Wandler 142/142a bzw. den Unterschied der beiden Vorspannungen entsprechend einstellt. Die Messung der asymmetrischen Last kann auch selbst durch einen internen Sensor stattfinden. Die Ansteuerung 120 bzw. die elektrische Schaltung 320 kann aber auch selbst die asymmetrische Belastung an dem auslenkbaren Element über mechanischzu-elektrische-Umwandlung der MEMS-Wandler 141/142 erfassen.

Ein wichtiger Aspekt ist, dass mit der symmetriebedingten Unterdrückung harmonischer Oberschwingungen gerader Ordnung eine dynamisch verursachte Verschiebung der Ruhelage bzw. Arbeitspunkt unterbunden werden kann. Eine solche dynamische Verschiebung des Arbeitspunktes würde sonst die Systemeigenschaften in Abhängigkeit von der spektralen Zusammensetzung des Eingangssignals bzw. Stimulus bei Verwendung als Aktor bzw. als Sensor verändern, ist also besonders nachteilig.

Mit der Erhöhung der Linearität des Systems wird auch das Auftreten subharmonischer Resonanzen unterdrückt. Subharmonische Resonanzen treten regelmäßig bei der Ansteuerung 120 der nichtlinearen als Aktor betriebenen Biegewandler 100 mit breitbandigen Signalen auf. Sie beschränken den technisch nutzbaren Frequenzbereich auf einen Bruchteil der Resonanzfrequenz, typischerweise 1/2, 1/3, 1/5 etc., da bei ihrem Durchfahren auf der Frequenzachse der Ausgang der Ansteuerelektronik 120 praktisch kurzgeschlossen wird. Subharmonische Resonanzen können in der Regel nur unvollkommen durch aktive Rücckopplungssysteme 1200 vermindert werden, da mit der Nichtlinearität auch das Phänomen der Kreuzmodulation auftritt. Zudem erhöhen aktive Feedbacksysteme bzw. Rückkopplungssysteme 1200 die Systemkosten. Eine Unterdrückung subharmonischer Resonanzen durch Erhöhung der Systemdämpfung bzw. Leistungsdissipation senkt die Antriebseffizienz unnötig stark und ist insbesondere für mobile Anwendungen nachteilhaft. Demgegenüber ist die Linearisierung des verformbaren Elementes besonders vorteilhaft.

Ein weiterer Aspekt besteht darin, erkannt zu haben, dass sich mittels des Designs von Ansteuerung 120 und elektrischer Schaltung 320 und MEMS-Wandler 141,141a,142,142a die Sensitivität, also Steilheit seiner Übertragungsfunktion, durch Veränderung der Festspannung $U_0$ einstellen lässt. Die Sensitivität ist proportional dem Quadrat der

Festspannung $U_0$:

$$Sensitivität \propto (U_0)^2$$

Folglich kann beispielsweise durch Erhöhung der Festspannung $U_0$ die zur Erreichung der maximalen Auslenkung erforderliche Amplitude der Signalspannung $U_{signal}$ - ohne wesentliche Einbußen bei der Linearität - verringert werden.

Für den Einsatz des Biegewandlers 300 als Aktor 100 ist dieser Aspekt bedeutsam, weil die zum Betrieb erforderliche, elektrische Blindleistung proportional zu dem Quadrat der Signalspannung $U_{signal}$ ist und durch Vergrößerung der Vorspannung $U_0$ stark reduziert werden kann.

$$Blindleistung \propto \left(U_{signal}\right)^2$$

Eine hohe Blindleistungsaufnahme erzeugt in der Ansteuerelektronik 120 hohe elektrische Verluste und ist nicht kompatibel mit dem Einsatz des Biegewandlers in mobilen Anwendungen. Gegenüber dem Stand der Technik, wie z. B. kapazitive, magnetische oder piezoelektrische Aktorik, ist dieser Aspekt damit ein deutlicher Vorteil.

Für den Einsatz des Biegewandlers als Sensor ist dieser Aspekt bedeutsam, weil damit die Empfindlichkeit des Sensors stark erhöht werden kann und beispielsweise das Signal-Rausch-Verhältnis eines mit diesem Biegewandler realisierten Mikrofons deutlich verbessert werden kann.

Sowohl für den Einsatz des Biegewandlers als Aktor, als auch als Sensor ist dieser Aspekt bedeutsam, weil mit einer günstigen Wahl der Signalspannungsamplitude die Kosten für die erforderliche Ansteuerelektronik 120 bzw. Schaltung 320 deutlich gesenkt werden können. Beispielsweise wird die Herstellung von CMOS-Elektronik für Spannungen < 12 V besonders günstig. Signalspannungen < 5V erfüllen die bei preisgünstigen Elektronikkomponenten weit verbreiteten TTL-Standard. Signalspannungen < 1,3 V können direkt, d. h. ohne zusätzliche Treiberschaltung, von den elektrischen Ausgängen moderner Signalprozessoren angesteuert werden.

Die Sensitivität, d. h. Tangentensteigung der Übertragungsfunktion im Nullpunkt, des verformbaren Elementes 110,110a lässt sich durch konstruktive Maßnahmen verbessern. Entscheidend ist dabei die Erkenntnis, dass die Sensitivität proportional zu dem Verhältnis der maximal in den Bimorph-Strukturen 141,141a,142,142a deponierbaren elektrostatischen Energie zu der in dem verformbaren Element 110,110a bei maximaler Auslenkung deponierten Energie der elastischen Verformung ist:

$$Sensitivität \propto \frac{max.\, Elektrostatische\; Energie\; der\; Bimorphstrukturen}{max.\, elastische\; Energie\; der\; verformbaren\; Elemente}$$

Damit lässt sich die Sensitivität des Biegewandlers (ceteris paribus) konstruktiv durch eine Erhöhung der maximal in den Bimorph-Strukturen 141,141a,142,142a deponierbaren elektrostatischen Energie und/oder durch eine Verminderung der für die maximale Auslenkung erforderliche Verformungsenergie vergrößern. Entsprechend kann die zur Einstellung einer bestimmten Sensitivität erforderliche Festspannung $U_0$ abgesenkt werden.

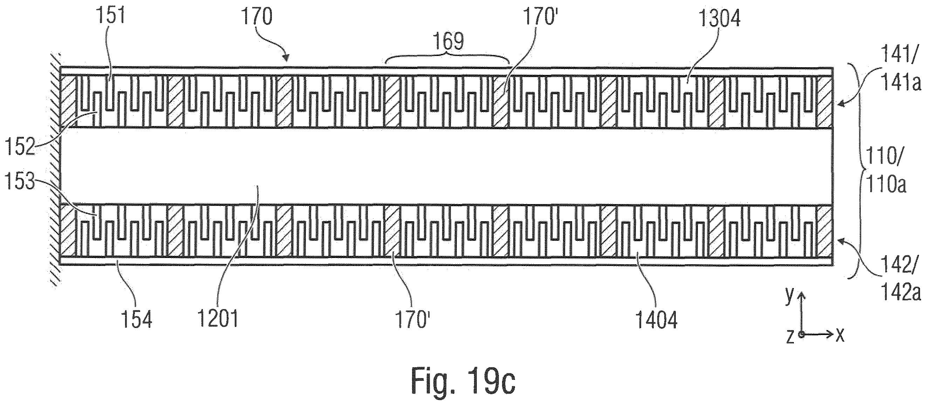

Die maximal in den Bimorph-Strukturen 141,141a,142,142a deponierbare elektrostatische Energie kann durch eine geschickt gewählte Elektrodengeometrie und Anordnung erhöht werden. Beispielsweise kann zwischen den Elektroden eine interdigitale Anordnung in Form einer Kammstruktur, wie in der Figur 19c dargestellt, angeordnet werden. Insbesondere zeigt Fig. 19c, wie Vorsprünge der Elektroden 151 und 152 des MEMS-Wandler 141(a) ineinandergreifen, wodurch die Kapazität erhöht wird und damit auch die deponierbare elektrostatische Energie. Selbiges ist auch für den anderen MEMS-Wandler 142/142a gezeigt.

Ebenfalls ist es möglich, dass die maximal in den verformbaren Elementen 110/110a deponierbare elastische Energie durch ein geschickt gewähltes mechanisches Design verringert werden kann.

Beispielsweise kann gemäß dem Prinzip des Tragwerkes das bei der Auslenkung verformte Festkörpervolumen minimiert werden.

Bei Biegewandlern 100, 300, bei denen das verformbare Element 110,110a ein einseitig eingespannter Balken ist und dessen bestimmungsgemäße Bewegungsrichtung in der Wafer-Ebene erfolgt, wird die maximale Balkenlänge und damit die tiefst mögliche Resonanzfrequenz durch den vertikalen Pull-In begrenzt. Während für den vertikalen Pull-In die Federsteifigkeit des verformbaren Elementes 110,110a senkrecht zur Bewegungsrichtung maßgebend ist, ist für die Höhe Resonanzfrequenz die Federsteifigkeit in Bewegungsrichtung ausschlaggebend. Der oben beschriebene Zusammenhang zwischen wirksamer Federsteifigkeit und Festspannung $U_0$ gilt in erster Linie für die Federsteifigkeit in Bewegungsrichtung. Diese Erkenntnis ermöglicht es, die tiefst mögliche Resonanzfrequenz eines gegebenen verformbaren Elementes 110,110a mittels Erhöhung der Festspannung gegenüber der mechanisch bestimmten Grenze weiter abzusenken.

Die wirksame Federsteifigkeit k' des verformbaren Elementes 110,110a kann mittels der Festspannung $U_0$ gegenüber der mechanischen Federsteifigkeit k abgesenkt werden:

$$k' = k \left( 1 - \left( \frac{U_0}{U_{max}} \right)^2 \right)$$

Mit dieser Erkenntnis lassen sich elektronisch durchstimmbare Biegewandler 100/300 bzw. Biegwandler-Systeme realisieren, bei denen die Resonanzfrequenz bzw. das dynamische Verhalten unterhalb der Resonanzfrequenz in Abhängigkeit von der Anwendungssituation über die Festspannung $U_0$ eingestellt werden kann.

Nachfolgend werden einige Ausführungsbeispiele, die auf einer Zusammenarbeit einer Mehrzahl von Biegewandlern basieren, beschrieben.

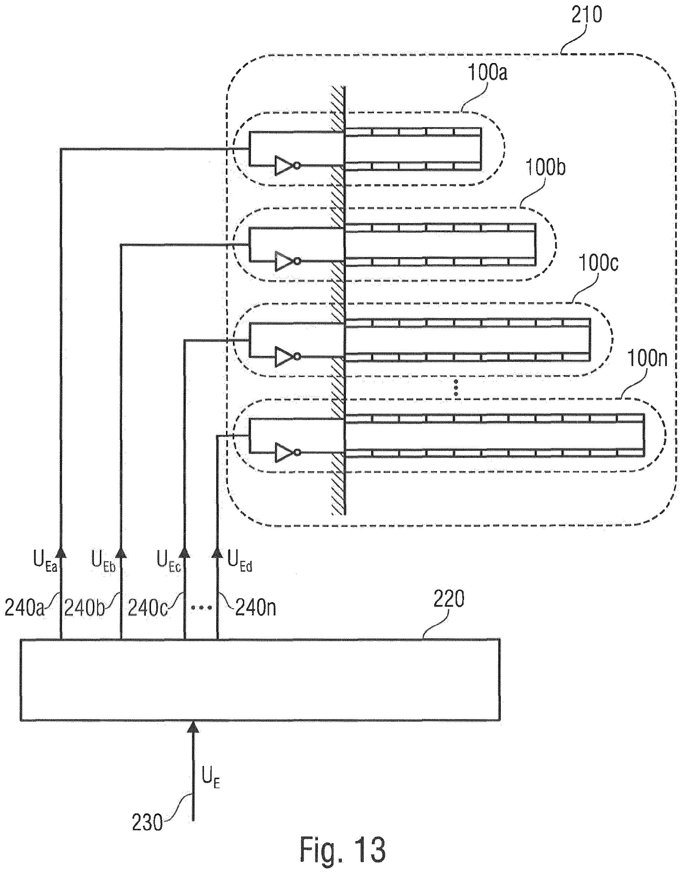

In Fig. 13 ist ein Biegewandlersystem 210 mit einer Mehrzahl von Biegewandlern 100a-n und eine Aufteilungsschaltung 220 dargestellt. Die Anzahl n kann Zwei oder mehr betragen. Jeder der Mehrzahl von Biegewandlern 100a-n wird jeweils als Aktor verwendet und ist, wie bei der Fig. 9 beschrieben, konstruiert, aber unterscheiden sich gegenseitig hinsichtlich spektraler Wirksamkeit bzw. Sensitivität. Das kann wie nachfolgend beschrieben erzielt werden: In Fig. 13 ist angedeutet, dass die gegenseitige spektral unterschiedliche Wirksamkeit durch gegenseitig unterschiedlich Dimensionierung des auslenkbaren Elements erzielt wird. Die Aufteilungsschaltung 220 ist mit den Biegewandlern 100a-n einzeln verkoppelt und ist ausgebildet, um ein Gesamteingangssignal $U_E$ 230 spektral auf eine Mehrzahl von Eingangssignalen $U_{Ea}$ - $U_{Ed}$ 240a-n für die Mehrzahl von Biegewandlern 100a-n aufzuteilen, in der Art, dass jeder Biegewandler 100a-n einen Spektralanteil des Eingangssignals 230 erhält, für das seine Sensitivität und Linearität hoch ist, bzw. das für das dem jeweiligen Biegewandler zugeordnete Frequenzband passend ist. Die Aufteilungsschaltung ist optional und könnte auch fehlen. Die Linearität lässt sich durch die in Fig. 13 veranschaulichte Verwendung mehrerer Biegewandler 100a-n erhöhen. Die mechanische Wirkung der Biegewandler 100a-n addiert sich, so dass der einzelne Biegewandler der Anordnung nur in einem Bruchteil des Dynamikbereichs bzw. der Auslenkung betrieben werden kann. Ein einzelner Biegewandler mit vergleichbarer Wirkung, d.h. eine Anordnung mit nur einem verformbaren Element und mit gleicher Effektivität, würde ein hohes Maß an Präzision und Maßnahmen erfordern, um die gleiche Linearität zu ermöglichen.

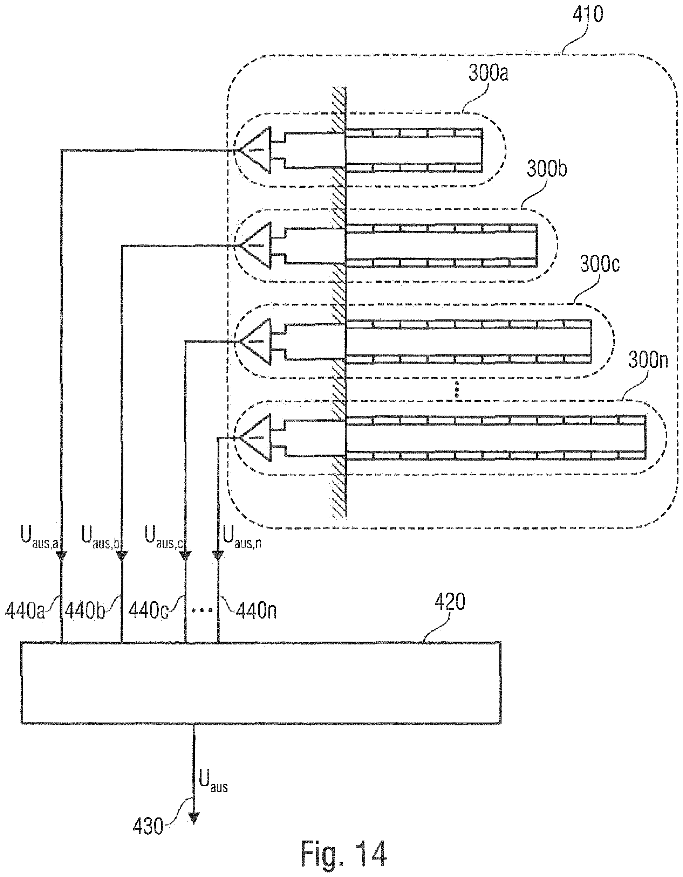

In Fig. 14 ist ein Biegewandlersystem 410 mit einer Mehrzahl von Biegewandlern 300a-n und einer Schaltung 420 dargestellt. Die Anzahl n kann Zwei oder mehr betragen. Die Biegewandler 300a-n, die jeweils als Sensor betrieben werden, sind wie der Biegewandler in Fig. 10 aufgebaut. Die Schaltung 420 ist mit den Biegewandlern 300a-n verkoppelt, um aus einer Mehrzahl von Ausgangssignalen $U_{aus,a}$ - $U_{aus,n}$ 440a-n der Mehrzahl von Biegewandlern 300a-n ein Gesamtausgangssignal $U_{aus}$ spektral zusammenstellen. Wie bei Fig. 13 unterscheiden sich die Biegenwandler gegenseitig hinsichtlich ihrer spektralen Wirksamkeit bzw. Sensitivität, was, wie in Fig. 14 angedeutet, dadurch realisiert werden kann, dass dieselben gegenseitig unterschiedlich dimensioniert sind. Da jeder Biegewandler 100a-n für einen jeweiligen Spektralanteil bzw. ein jeweiliges Frequenzband ausgelegt ist, für das seine Sensitivität und Linearität hoch ist, lässt sich die Linearität erhöhen, wobei sich die Wirkung der Biegewandler addiert. Ein einzelner Biegewandler mit vergleichbarer Wirkung, d.h. eine Anordnung mit nur einem verformbaren Element und mit gleicher Effektivität, würde ein hohes Maß an Präzision und Maßnahmen erfordern, um die gleiche Linearität zu ermöglichen.

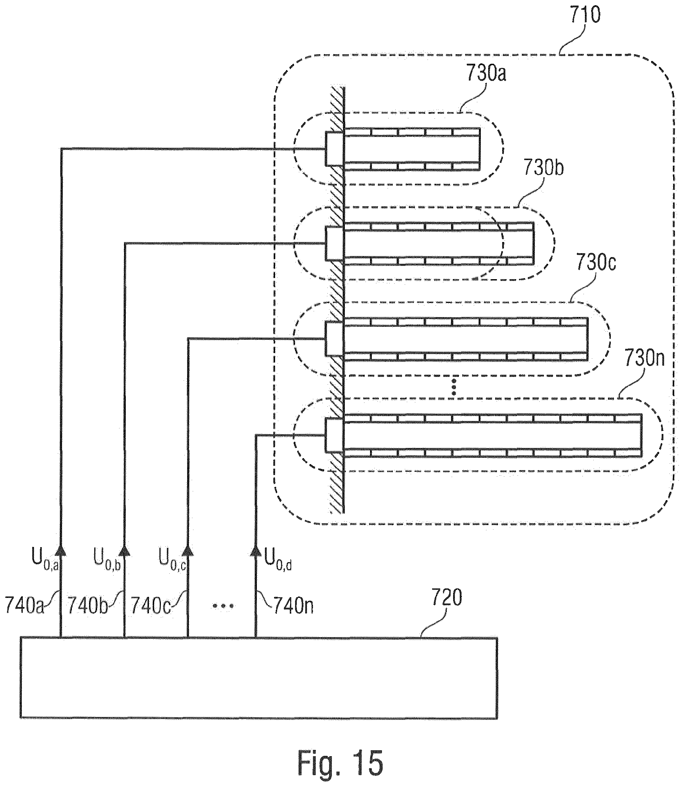

Fig. 15 zeigt ein Biegewandlersystem mit einer Mehrzahl von Biegewandlern 730a-n und einer Schaltung für eine Vorspannungseinstellung, nämlich 720. Die Biegewandler sind in Fig. 15 mit dem Bezugszeichen 730a-n angezeigt, um anzudeuten, dass es solche sein können, die als Aktor verwendet werden, wie die Biegewandler 100a-n von Fig. 13, oder aber Biegewandler, die als Sensor betrieben werden, wie z. B. die Biegewandler 300a-n von Fig. 14. Anders als in Fig. 13 und 14 sind die Biegewandler 730a-n von Fig. 15 so dargestellt, dass sie sich hinsichtlich ihrer Dimensionierung nicht unterscheiden. Dennoch ist es möglich, die Biegewandler 730a-n hinsichtlich ihrer spektralen Wirksamkeit bzw. Sensitivät gegenseitig zu variieren. Dies übernimmt die Vorspannungseinstellungsschaltung 720. Sie ist in der Lage, die vorerwähnten Vorspannungen, mit denen die MEMS-Wandler in den auslenkbaren Elementen der Biegewandler 730a-n betrieben werden, individuell einzustellen. Durch diese Einstellung können wiederum die Biegewandler 730a-n hinsichtlich ihrer spektralen Wirksamkeit bzw. Sensitivität individualisiert werden bzw. für unterschiedliche Frequenzbänder zuständig gemacht werden. Die Vorspannungseinstellungsschaltung 720 könnte beispielsweise zusätzlich zu der Frequenzzerlegungsschaltung 220 bzw. zusätzlich zu der Zusammensetzungsschaltung 400 auch in den Systemen von Fig. 13 und 14 eingesetzt werden, um einen Feinabgleich der dortigen Biegewandler vorzunehmen. Umgekehrt könnte in Fig. 15 zusätzlich eine Schaltung 220/420 vorgesehen sein.

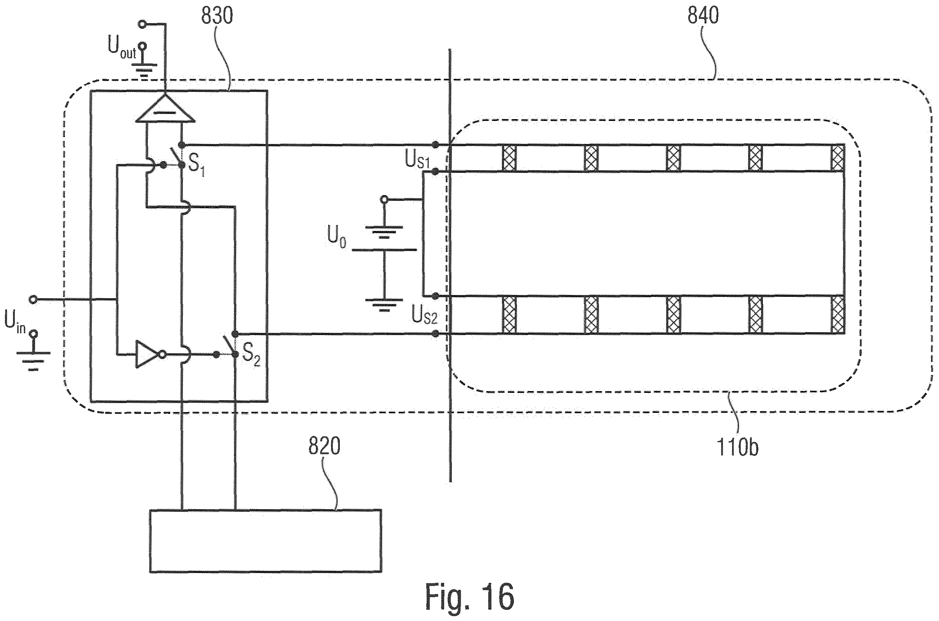

Es ist möglich, einen Biegewandler vorzusehen, der wahlweise als Sensor oder Aktor betrieben werden kann. Fig. 16 zeigt einen solchen Biegewandler 840. Der Biegewandler 840, der als Sensor und/oder als Aktor betrieben werden kann, ist mit einer Schaltung 820 ausgestattet, die ausgebildet ist, um den Biegewandler 840 als Sensor und/oder als Aktor zu betreiben. Der Biegewandler weist ein auslenkbares Element 110b auf, das aufgebaut ist wie das auslenkbare Element 110 in Fig. 9 und/oder das auslenkbare Element 110a in Fig. 10, und eine elektrische Schaltung 830, die ausgebildet ist, um entweder das erste und das zweite elektrische Signal $U_{s1}$, $U_{s2}$ abhängig von einem Eingangssignal $U_{in}$ zu variieren oder aus dem ersten und aus dem zweiten elektrischen Signal $U_{s1}$, $U_{s2}$ ein Ausgangssignal $U_{out}$ zu erzeugen. Die Schaltung 820 ist mit der Schaltung 830 verkoppelt und ist ausgebildet, um den Biegewandler 840 als Sensor und/oder als Aktor zu betreiben.

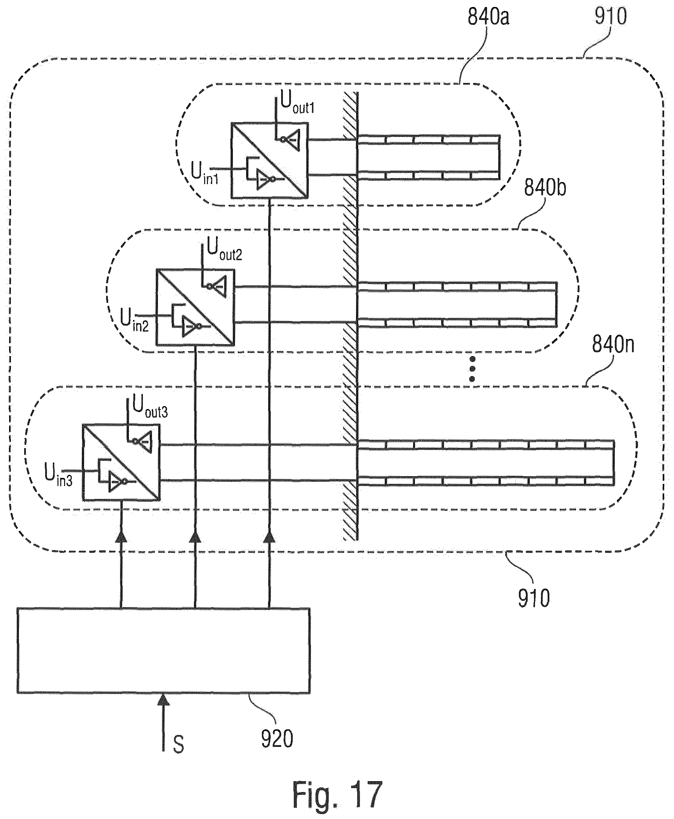

Auch solche hinsichtlich ihres Einsatzes als Aktor oder Sensor noch nicht festgelegten Biegewandler, wie einer der repräsentativ in Fig. 16 beschrieben worden ist, können zu einem System zusammengesetzt werden. Fig. 17 zeigt ein solches System.

In Fig. 17 sind ein Biegewandlersystem 910 und eine Schaltung 920 dargestellt. Das Biegewandlersystem weist eine Mehrzahl von Biegewandlern 840a-n auf. Die Biegewandler 840a-n können wie der Biegewandler 840 in Fig. 16 aufgebaut sein und als Aktor und/oder als Sensor betrieben werden. Die Schaltung 920 ist mit den Biegewandlern einzeln verkoppelt und ist derart ausgebildet, dass ein erster Teil der Gesamtmenge der Biegewandler als Aktoren ausgewählt wird und ein zweiter Teil der Gesamtmenge der Biegewandler als Sensoren ausgewählt wird, wobei die Aufteilung der Teilmenge abhängig von einem Steuersignal S erfolgt. In anderen Worten ausgedrückt, befiehlt die Schaltung 920 der Schaltung 830 von Fig. 16, entweder die Funktion als Ansteuerschaltung zu übernehmen oder die Funktion als elektrische Schaltung.

Wie schon oben erwähnt, sind die vorgestellten Systeme aus mehreren Biegewandlern dazu in der Lage, eine verbesserte Linearität zu erzielen. Die Verwendung mehrerer Biegewandler geschieht dabei so, dass sich ihre mechanische Wirkung aufaddiert, so dass der einzelne Biegewandler der jeweiligen Anordnung bzw. des jeweiligen Systems beispielsweise nur noch an einem Bruchteil des Gesamtdynamikbereichs des Systems betrieben werden muss. Ein Aktuator vergleichbarer Geometrie mit einer Anordnung aus nur einem verformbaren Element und gleicher Funktion würde eine höhere Präzision und mehr Maßnahmen erfordern.

Nachfolgend werden weitere Ausführungsbeispiele von Biegewandlern und auslenkbaren Elementen beschrieben.

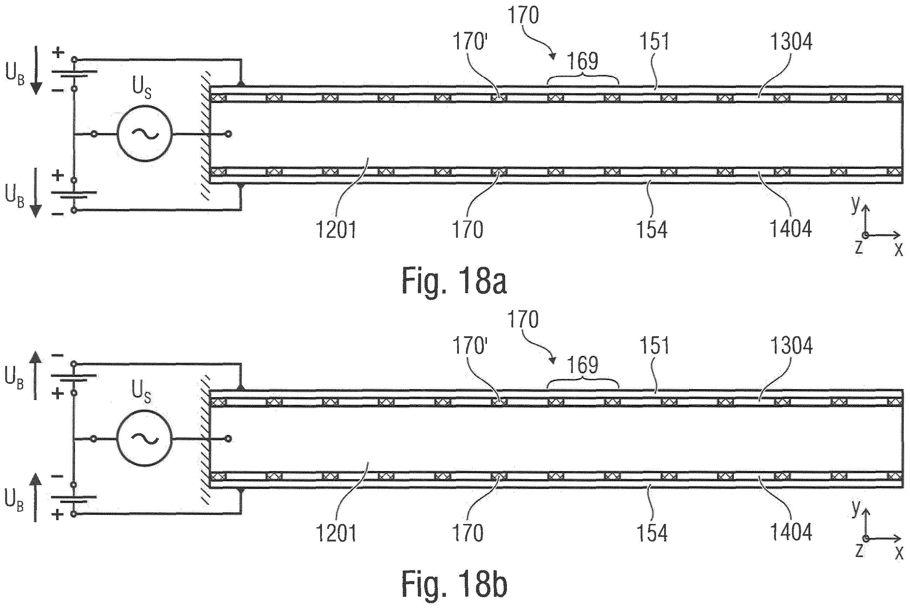

Der Aufbau eines auf einem Biegewandler basierenden und als Aktor betriebenen Bauelements ist anhand eines einseitig eingespannten Balkens noch einmal in Figur 18a-d gezeigt. Beidseitig eines elektrisch leitfähigen Balkens 1201 wird eine isolierende Abstandhalterschicht 170' und ein elektrisch leitfähiges Material 151 und 154 angebracht. Die isolierende Abstandhalterschicht 170' kann beispielsweise durch eine Opferschichttechnologie lateral so strukturiert werden, sodass sich ein dünner Hohlraum 1304 und 1404 zwischen den Elektroden 1201 und 151 bzw. zwischen den Elektroden 1201 und 154 in jedem der Segmente 169 ausbildet, in die das auslenkbare Element entlang der Längsrichtung x segmentiert ist, und an den Segmentgrenzen 170 isolierende Abstandshalter verbleiben. Der Hohlraum besitzt die Dicke der dielektrischen Opferschicht und definiert somit den Plattenabstand des Kondensators. Legt man nun eine elektrische Spannung zwischen den Elektroden 1201 und 151 bzw. zwischen den Elektroden 1201 und 154 an, so resultiert aus den Kräften in y-Richtung des elektrostatischen Feldes eine laterale Dehnung auf der Oberfläche des Balkens in x-Richtung. Infolge der Oberflächendehnung wird der Balken 1201 ausgelenkt. Werden regelmäßige laterale Geometrien genutzt, so ist die Oberflächendehnung näherungsweise konstant und es stellt sich ein sphärisches Deformationsprofil ein.

Die elektrische Verschaltung erfolgt derart, dass an den äußeren Elektroden 151 und 154 eine elektrische Gleichspannung $U_B$ und an der mittleren Elektrode, bzw. des Balkens eine Signalwechselspannung $U_S$, wie z. B. ein Audiosignal, angelegt wird. Die äußeren Elektroden 151 und 154 werden mit einer elektrischen Vorspannung beaufschlagt. Die Amplitude der Signalwechselspannung $U_S$ ist gleich oder vorzugsweise kleiner der elektrischen Vorspannung $U_B$. Das höchste elektrische Potential im System ist wirtschaftlich sinnvoll zu wählen und kann im Einklang mit geltenden Richtlinien und Normen stehen. Durch die elektrische Vorspannung der äußeren Elektroden folgt die Verkrümmung des Balkens der Signalwechselspannung $U_S$. Eine positive Halbwelle der Signalwechselspannung $U_S$ führt zu einer Verkrümmung des Balkens 1201 in negative y-Richtung. Eine negative Halbwelle führt zu einer Verkrümmung des Balkens 1201 in positive y-Richtung. In den Figuren 18a-d sind weitere Varianten der elektrischen Kontaktierung gezeigt.

Figur 18a zeigt die jeweils äußeren Elektroden mit einer elektrischen Gleichspannung beaufschlagt, jedoch im Vergleich zur Darstellung in Figur 18b mit einem entgegengesetzten elektrischen Potential.

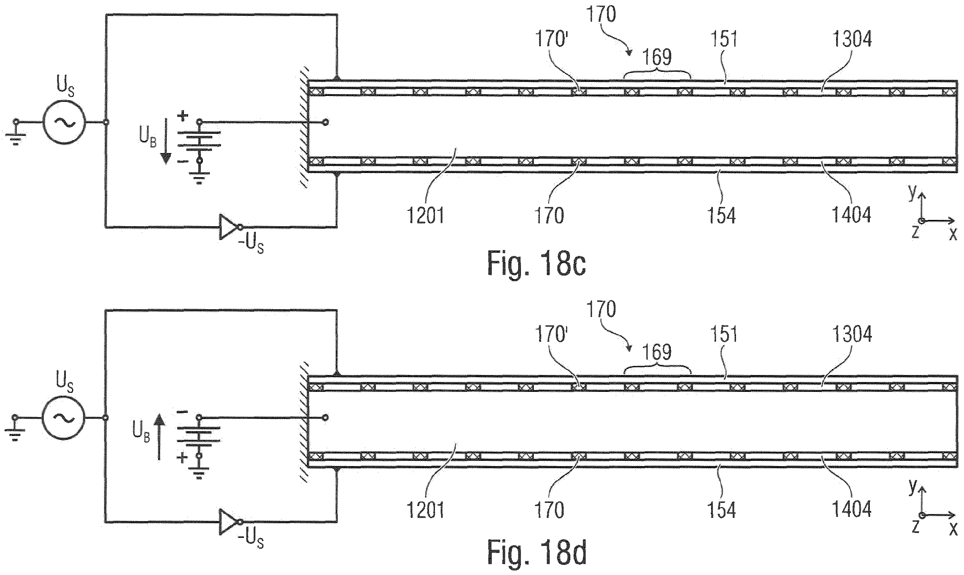

Figur 18c und Figur 18d zeigen Varianten, mit einer elektrischen Vorspannung der inneren Elektrode(n). Die Signalspannung wird auf die äußeren Elektroden angelegt.

Anstelle einer elektrischen angelegten Vorspannung an die äußere(n) oder innere(n) Elektrode(n) ist eine Dauerpolarisation der äußeren oder inneren Elektrode(n) als Elektret, wie z.B. Siliziumdioxid, möglich. Anstelle von den in vorangegangenen Figuren gezeigten Spannungsquellen können Stromquellen eingesetzt werden.

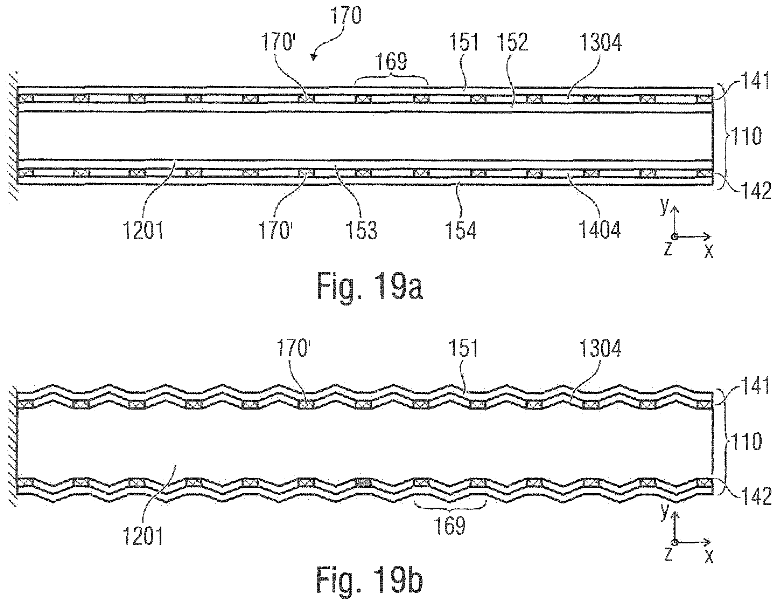

Fig. 19a-c zeigen weitere Ausführungsbeispiele für das auslenkbare Element bzw. alternative Topografien der Elektroden der MEMS-Wandler, wobei der Übersichtlichkeit halber die Ansteuerung nicht gezeigt ist. Die Bezugszeichen und die grundsätzliche Beschreibung der Fig. 18a-c gelten weiterhin.

Dass das zu verkrümmende Element bzw. das Gro bzw. der Träger 1201 selbst als Elektrode fungieren kann, ist in Fig. 18a-d veranschaulicht worden. Fig. 19a veranschaulicht die mögliche Ausgestaltung, wonach stattdessen unmittelbar auf der Oberfläche bzw. den den Plattenkondensatoren zugewandten Ober- und Unterseiten des Trägers 1201 jeweils gesondert eine proximale Elektrode des jeweiligen Plattenkonsensators vorgesehen ist. Dabei sind 152 und 153 die inneren bzw. proximalen Elektroden und 151 und 154 die äußeren bzw. distalen Elektroden.

Die Topografie der Elektroden kann strukturiert sein, wie es schematisch in Figur 19b dargestellt ist. Es sind darüber hinaus anders geformte Elektroden denkbar, z.B. kuppelförmig. Um die Kondensatorfläche und damit die deponierbare elektrostatische Energie weiter zu vergrößern sind kammförmige Elektroden, wie in der Figur 19c dargestellt denkbar.

Das zu verkrümmende Element, wie z.B. Balken, kann einseitig oder beidseitig eingespannt sein.

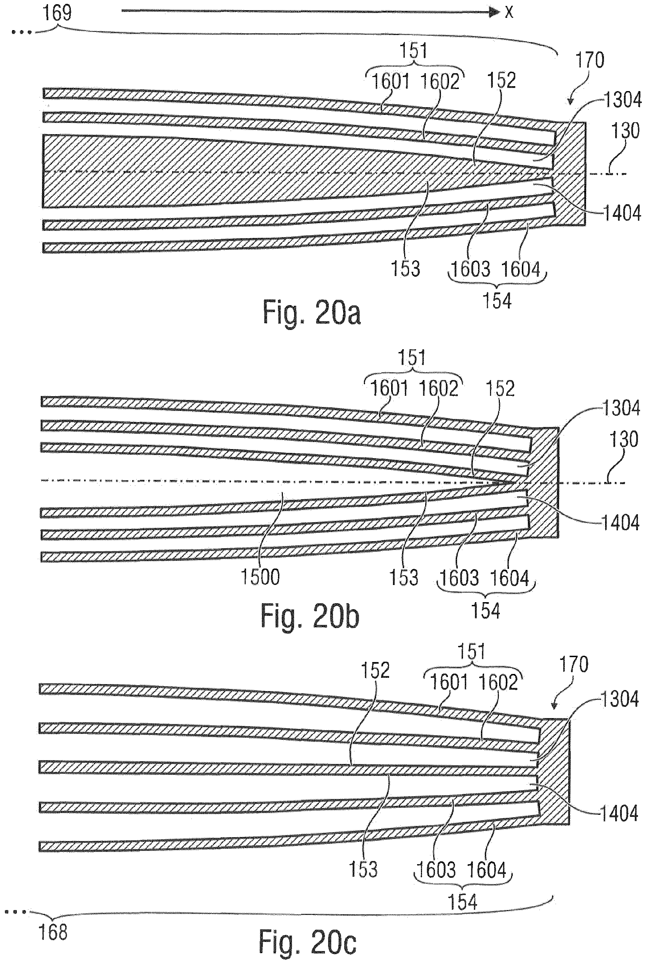

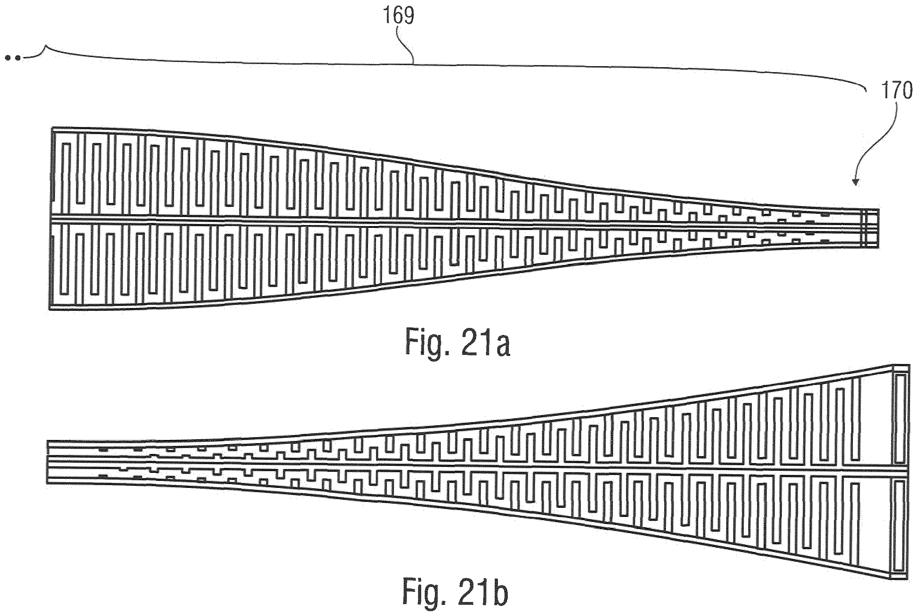

In Figuren 20a-c und 21a-b sind weitere mögliche Ausführungsbeispiele von auslenkbaren Elementen dargestellt. In diesen Figuren sind jeweils halbe Segmente 169 gezeigt. Die andere Hälfte kann jeweils symmetrisch dazu geformt sein. Der Biegewandler bzw. das auslenkbare Element besteht aus einer beispielsweise geraden Anzahl von solcher Art gebildeten Segmenten 169 hintereinander in Längsrichtung x. In den Darstellungen ist lediglich die Topografie dargestellt, ohne zwischen Elektroden und isolierender Abstandhalterschicht zu unterscheiden.

Insbesondere zeigt Fig. 20a den Fall, dass jedes Segment 169 so gebildet ist, dass die Elektroden 151 und 154 der beiden einander über die Flächenschwerpunktfaser 130 gegenüberliegenden Elektroden 151 und 154 jeweils von der Flächenschwerpunktfaser 130 vorgewölbt sind, wobei der Zwischenraum 1304 und 1404, der dieselben von der jeweils anderen Elektrode 152 bzw. 153 trennt, in Richtung der Flächenschwerpunktfaser 130 von in etwa konstanter Dicke ist. Anders ausgedrückt sind auch die inneren Elektroden 152 und 153 in den Segmenten 169 jeweils von der Flächenschwerpunktfaser 130 weggewölbt ausgestaltet. In dem Fall von Fig. 21a ist dabei das auslenkbare Element zwischen den inneren Elektroden 152 und 153 materialschlüssig gebildet, d. h. ohne Hohlraum. In Fig. 21b ist eine Abwandlung des Ausführungsbeispiels von Fig. 21a gezeigt, bei dem zwischen den Elektroden 152 und 153 ein Hohlraum 1500 gebildet ist. Fig. 21c zeigt eine Abwandlung, bei der die inneren Elektroden 152 und 153 nicht von der Flächenschwerpunktfaser 130 weg vorgebeult ausgebildet sind, sondern parallel zur Flächenschwerpunktfaser 130 verbleiben, so dass der diese Elektroden 152, 153 von den jeweils distalen Elektroden 151/154 trennende Hohlraum 1304/1404 in Längsrichtung x von variierender, insbesondere von den Segmentgrenzen 170 zur Segmentmitte hin größer werdende Dicke aufweist.

Fig. 20a-c zeigen dabei eine Ausgestaltung, bei der die distelen Elektroden 151 und 154 mehrlagig ausgeführt sind. Das heißt, in den Ausführungen von Fig. 20a und 20b ist in jedem Segment das auslenkbare Element so ausgestaltet, dass es sich zwischen den Segmentgrenzen 170 in beide Richtungen weg von der Flächenschwerpunktfaser 130 vorwölbt, also zur Segmentmitte hin dicker wird, so dass sich dementsprechend auch die proximalen Elektroden 151 und 152 vorwölben. Konform zu den proximalen Elektroden 152 und 153 erstrecken sich jeweils auf der der Flächenschwerpunktfaser 130 abgewandten Seite der proximalen Elektroden 152 und 153 zwei Lagen 1601,1602, die die Elektrode 151 bilden, und Elektrodenlagen 1603 und 1604, die die Elektrode 151 bilden. Zwischen den Elektrodenpaaren 1601 und 1602 bzw. 1603 und 1604 ist ebenfalls wieder ein Hohlraum von entlang der Längrichtung x konstanter Dicke gebildet. Die Lagen 1601-1602 einerseits und 1603 und 1604 andererseits können mit gleichem Potential beauflschlagt werden. Alternativ wäre es möglich, dass jeder MEMS-Wandler modifiziert wird, um mit drei Elektroden 152, 1601 und 1602 bzw. 153, 1603 und 1604 ausgestaltet zu sein. Fig. 20c stellt dar, dass auch der Hohlraum zwichen den Paaren von Lagen 1601 und 1602 bzw. 1603 und 1604 von entlang der Längsrichtung x variierender, nämlich in der Segmentmitte maximaler Dicke sein könnte.

Fig. 21a und 21b zeigen eine Modifikation der Ausgestaltung von Fig. 19c, mit der Ausnahme, dass die distalen Elektroden 151 und 154 in jedem Segment konkav bzw. konvex gewölbt ausgeführt sind, d.h. im konvexen Fall nach Fig. 21a in der Segmentmitte am meisten nach außen vorgewölbt und im Fall von Fig. 21b am nächsten zu den proximalen Elektroden 152 und 153 hin gewölbt sind, während Vorsprünge der Elektroden 151 -154 kammartig ineinandergreifen bzw. ineinanderragen.

Die Figuren 20a bis 21b zeigen Topografien, die gegenüber den bisher aufgezeigten Topografien eine größere deponierbare Energie zulassen und damit eine größere Auslenkung des Aktors ermöglichen. Insbesondere ermöglicht der Doppelelektrodenaufbau der distalen Elektroden nach Fig. 20a-c und die konkav-konvex gekrümmte Ausgestaltung distaler Elektroden mit interdigitaler Ausführung der Elektroden Vorteile hinsichtlich hoher deponierbarer Energie und gleichzeitig hinsichtlich einer werkstoffgerechten Topologie, um eine größtmögliche Auslenkung zuzulassen.

Fig. 22 offenbart ein Ausführungsbeispiel eines asymmetrischen Aktors 100 bzw. eines Biegwandlers 100 mit einem asymmterisch ausgestalteten auslenkbaren Element 110, der einseitig eingespannt ist. Hierbei sind die Elektroden 151 und 152 des ersten MEMS-Wandlers 141 dicker ausgeführt als die Elektroden 153 und 154 des zweiten MEMS-Wandlers 142. Damit einher gehend ist auch der Abstand der Elektroden 151 und 152 vergrößert. Vorteilhaft ergibt sich durch den asymmetrischen Aufbau eine asymmetrische Wirkung des Aktors. Fig. 22 veranschaulicht somit eine Möglichkeit einer konstruktiven Asymmetrie, die zur Kompensation von äußeren Asymmetrienverwendet werden kann.

Obige Ausführungsbeispiele ermöglichen es folglich, dicke Wandler zu konstruieren, die in einem großen Dynamik- und Frequenzbereich besonders linear arbeiten. Dabei werden gemäß Ausführungsbeispielen lediglich moderate Spannungen benötigt.. Sie besitzen gleichzeitig eine hohe Leistungsfähigkeit.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.


**Patentansprüche**

1.  Biegewandler als Aktor (100, 100a-n, 730a-n), mit einem auslenkbaren Element (110,110a-n, 1120,1220, 1300) mit

    einem ersten sich entlang einer Flächenschwerpunktfaser (130,130a) des auslenkbaren Elements erstreckenden mikroelektromechanischen Wandler (141,141a-b,1016a), der bei Anlegen eines ersten elektrischen Signals ($U_S$, $U_{S1}$, $U_{Signal}$, $U_{Signal1}$) das auslenkbare Element (110,110a-n, 1120,1220, 1300) in eine erste Richtung (161, 161b) auslenkt, und
    einem zweiten sich entlang der Flächenschwerpunktfaser (130,130a) erstreckenden mikroelektromechanischen Wandler (142,142a-b,1016b), der bei Anlegen eines zweiten elektrischen Signals ($U_S$, $U_{S2}$, $U_{Signal}$, $U_{Signal2}$) das auslenkbare Element in eine zweite zu der ersten entgegengesetzten Richtung (162, 162b) auslenkt,

    wobei die Flächenschwerpunktfaser (130,130a) einen Pfad definiert, der eine Vielzahl an Punkten verbindet, die sich aus Flächenschwerpunkten einer Vielzahl an aufeinanderfolgenden Querschnittsflächen des auslenkbaren Elements (110,110a-n, 1120,1220, 1300) quer zur Längsrichtung ergeben, und sich die Flächenschwerpunktfaser (130,130a) zwischen einander abgewandten Seiten des ersten und des zweiten mikroelektromechanischen Wandlers (141,141a-b, 142,142a-b, 1016a, 1016b) befindet, und
    wobei sich die Flächenschwerpunktfaser (130,130a) zwischen einander abgewandten Seiten des ersten und des zweiten mikroelektromechanischen Wandlers (141,141a-b, 142,142a-b, 1016a, 1016b) befindet, und

    einer elektrischen Ansteuerung (120, 1013a), die ausgebildet ist, um das erste elektrische Signal ($U_S$, $U_{S1}$, $U_{Signal}$, $U_{Signal1}$) und das zweite elektrische Signal ($U_S$, $U_{S2}$, $U_{Signal}$, $U_{Signal2}$) abhängig von einem Eingangssignal ($U_E$, $U_{Ea}$ - $U_{Ed}$, $U_{in}$, $U_{in1}$ - $U_{in3}$) zu variieren, sodass eine Änderung des ersten elektrischen Signals ($U_S$, $U_{S1}$, $U_{Signal}$, , $U_{Signal1}$) und eine Änderung des zweiten elektrischen Signals ($U_S$, $U_{S1}$, $U_{Signal}$, , $U_{Signal2}$) abhängig von dem elektrischen Eingangssignal ($U_E$, $U_{Ea}$ - $U_{Ed}$, $U_{in}$, $U_{in1}$ - $U_{in3}$) ist, und die Phasen des ersten und zweiten elektrischen Signals ($U_S$, $U_{S1}$, $U_{S2}$, $U_{Signal}$, $U_{Signal1}$, $U_{Signal2}$) zueinander verschoben sind, **dadurch gekennzeichnet, dass**
    der erste mikroelektromechanische Wandler (141,141a-b,1016a) und der zweite mikroelektromechanische Wandler (142,142a-b,1016b) einen entlang einer Längsrichtung des auslenkbaren Elementes segmentierten (169) Plattenkondensator aufweisen.

2.  Biegewandler (100,100a-n,300,300a-n,730a-n,840, 840a-n) gemäß Anspruch 1, bei dem die Elektroden (151-154, 151a-154a) der ersten und zweiten Plattenkondensatoren interdigital ausgeführt sind.

3.  Biegewandler (100,100a-n,300,300a-n,730a-n,840, 840a-n) gemäß Anspruch 1, bei dem die elektrische Ansteuerung (120, 1013a, 1110, 1210) ausgebildet ist, um eine Kombination einer ersten Vorspannung ($U_0$, $U_{01}$, $U_{0a}$ - $U_{0n}$, $U_B$) und eines von dem Eingangssignal ($U_E$, $U_{Ea}$ - $U_{Ed}$, $U_{in}$, $U_{in1}$ - $U_{in3}$) abhängigen ersten Signalanteils als das erste elektrische Signal ($U_S$, $U_{S1}$, $U_{Signal}$, $U_{Signal1}$) an den ersten mikroelektromechanischen Wandler (141,141a-b,1016a) und/oder eine Kombination einer zweiten Vorspannung ($U_0$, $U_{02}$, $U_{0a}$ - $U_{0n}$, $U_B$) und eines von dem Eingangssignal ($U_E$, $U_{Ea}$ - $U_{Ed}$, $U_{in}$, $U_{in1}$ - $U_{in3}$) abhängigen zweiten Signalanteils als das zweite elektrische Signal ($U_S$, $U_{S1}$, $U_{Signal}$, $U_{Signal1}$) an den zweiten mikroelektromechanischen Wandler (142,142a-b,1016b) anzulegen.

4.  Biegewandler (100,100a-n,300,300a-n,730a-n,840, 840a-n) gemäß Anspruch 3, bei dem die erste Vorspannung ($U_0$, $U_{01}$, $U_{0a}$ - $U_{0n}$, $U_B$) und/oder die zweite Vorspannung ($U_0$, $U_{02}$, $U_{0a}$ - $U_{0n}$, $U_B$) so eingestellt ist oder sind, dass die Flächenschwerpunktfaser (130,130a) des auslenkbaren Elements ohne von dem Eingangssignal ($U_E$, $U_{Ea}$ - $U_{Ed}$, $U_{in}$, $U_{in1}$ - $U_{in3}$) abhängige Signalanteile und ohne externe mechanische Einflüsse auf das auslenkbare Element (110,110a-n, 1120,1220, 1300) nicht ausgelenkt ist.

5.  Biegewandler (100,100a-n,300,300a-n,730a-n,840, 840a-n) gemäß Anspruch 3 oder 4, bei dem die elektrische Ansteuerung (120, 1013a, 1110, 1210) so ausgebildet ist, dass die Federsteifigkeit des Biegewandlers und/oder die Sensitivität des Biegewandlers und/oder die Resonanzfrequenz des Biegewandlers durch Einstellung der Vorspannung ($U_0$, $U_{01}$, $U_{02}$, $U_{0a}$ - $U_{0n}$, $U_B$) oder der Vorspannungen ($U_0$, $U_{01}$, $U_{02}$, $U_{0a}$ - $U_{0n}$, $U_B$) an dem ersten und/oder an dem zweiten mikroelektromechanischen Wandler (141, 141a-b, 142, 142a-b, 1016a, 1016b) einstellbar ist.

6. Biegewandler (100,100a-n,300,300a-n,730a-n,840, 840a-n) gemäß einem der vorhergehenden Ansprüche, bei dem die elektrische Ansteuerung (120, 1013a, 1110, 1210) ausgebildet ist, um die Änderung des ersten und des zweiten elektrischen Signals ($U_S$, $U_{S1}$, $U_{S2}$, $U_{Signal}$, $U_{Signal1}$, $U_{Signal2}$) mit unterschiedlicher Amplitude durchzuführen, um eine asymmetrische Last (1130, 1230) auf das auslenkbare Element (110,110a-n, 1120,1220, 1300) zu kompensieren.

7. Biegewandler (100,100a-n,300,300a-n,730a-n,840, 840a-n) gemäß Anspruch 6, bei dem die elektrische Ansteuerung (120, 1013a, 1110, 1210) ausgebildet ist, um die Änderung des ersten und des zweiten elektrischen Signals ($U_S$, $U_{S1}$, $U_{S2}$, $U_{Signal}$, $U_{Signal1}$, $U_{Signal2}$) mit unterschiedlicher Amplitude durchzuführen, um die asymmetrische Last (1130, 1230) zu kompensieren, die eine konstruktive Asymmetrie des mikroelektromechanischen Wandlers (141, 141a-b, 142, 142a-b, 1016a, 1016b) und/oder eine asymmetrische Kraft, die auf das auslenkbare Element (110,110a-n, 1120,1220, 1300) wirkt, ist.

8. Biegewandler (100,100a-n,300,300a-n,730a-n,840, 840a-n) gemäß Anspruch 6 oder 8, bei dem die elektrische Ansteuerung (120, 1013a, 1110, 1210) eine Rückkopplungsschleife (1240) aufweist, um die Wirkung der asymmetrischen Last (1130, 1230) dynamisch zu kompensieren.

9. Biegewandlersystem (210,410,710,910) mit einer Mehrzahl von Biegewandlern (100,100a-n,300,300a-n,730a-n,840, 840a-n) gemäß einem der vorhergehenden Ansprüche 1 bis 8 wobei die Mehrzahl von Biegewandlern (100,100a-n,300,300an,730a-n,840, 840a-n) in Bezug auf eine Dimensionierung der mikroelektromechanischen Wandler (141, 141a-b, 142, 142a-b, 1016a, 1016b) übereinstimmen, wobei die Federsteifigkeiten und/oder die Resonanzfrequenzen und/oder die Sensitivitäten der Mehrzahl von Biegewandlern(100,100a-n,300,300an,730a-n,840, 840a-n) einzeln über eine Vorspannung an den ersten und/oder zweiten mikroelektromechanischen Biegewandler (100,100a-n,300,300a-n,730a-n,840, 840an) einstellbar ist.

10. Biegewandlersystem (210,410,710,910) mit einer Mehrzahl von Biegewandlern (100,100a-n,300,300a-n,730a-n,840, 840a-n) gemäß einem der vorhergehenden Ansprüche 1 bis 9 und einer Aufteilungsschaltung (220), die ausgebildet ist, um ein Gesamteingangssignal ($U_E$, $U_{in}$) spektral auf eine Mehrzahl von Eingangssignalen ($U_{Ea}$ - $U_{Ed}$, $U_{in1}$ - $U_{in3}$) für die Mehrzahl von Biegewandlern aufzuteilen.

## Claims

1. Bending transducer as actuator (100, 100a-n, 730a-n) with a deflectable element (110, 110a-n, 1120, 1220, 1300), comprising

   • a first microelectromechanical transducer (141, 141a-b, 1016a) extending along a centroid fiber (130, 130a) of the deflectable element that deflects the deflectable element (110, 110a-n, 1120, 1220, 1300) in a first direction (161, 161b) when a first electrical signal ($U_S$, $U_{S1}$, $U_{Signal}$, $U_{Signal1}$) is applied, and
   • a second microelectromechanical transducer (142, 142a-b, 1016b) extending along the centroid fiber (130, 130a) that deflects the deflectable element in a second direction (162, 162b) opposite to the first direction when a second electrical signal ($US$, $U_{S2}$, $U_{Signal}$, $U_{Signal2}$) is applied,

      wherein the centroid fiber (130, 130a) defines a path which connects a plurality of points resulting from centroids of a plurality of successive cross-sectional areas of the deflectable element (110, 110a-n, 1120, 1220, 1300) transverse to the longitudinal direction, and the centroid fiber (130, 130a) is located between sides of the first and second microelectromechanical transducers (141, 141a-b, 142, 142a-b, 1016a, 1016b) facing away from each other, and
      the centroid fiber (130, 130a) being located between sides of the first and second microelectromechanical transducers (141, 141a-b, 142, 142a-b, 1016a, 1016b) facing away from each other, and

   an electrical control (120, 1013a) configured to vary the first electrical signal ($U_S$, $U_{S1}$, $U_{Signal}$, $U_{Signal1}$) and the second electrical signal ($U_S$, $U_{S2}$, $U_{Signal}$, $U_{Signal2}$) depending on an input signal ($U_E$, $U_{Ea}$ - $U_{Ed}$, $U_{in}$, $U_{in1}$ - $U_{in3}$), such that a change of the first electrical signal ($U_S$, $U_{S1}$, $U_{Signal,}$, $U_{Signal1}$) and a change of the second electrical signal ($U_S$, $U_{S1}$, $U_{Signal}$, $U_{Signal2}$) depend on the electrical input signal ($U_E$, $U_{Ea}$ - $U_{Ed}$, $U_{in}$, $U_{in1}$ - $U_{in3}$), and the phases of the first and second electrical signals ($U_S$, $U_{S1}$, $U_{S2}$, $U_{Signal}$, $U_{Signal1}$, $U_{Signal2}$) are shifted with respect to one another, **characterized in that** the first microelectromechanical transducer (141, 141a-b, 1016a) and the second microelectromechanical transducer (142, 142a-b, 1016b) comprise a plate capacitor segmented (169) along a longitudinal direction of the deflected element,

2. Bending transducer (100, 100a-n, 300, 300a-n, 730a-n, 840, 840a-n) according to claim 1, wherein the electrodes (151-154, 151a-154a) of the first and second plate capacitors are configured to be interdigital.

3. Bending transducer (100, 100a-n, 300, 300a-n, 730a-n, 840, 840a-n) according to claim 1, wherein the electrical control (120, 1013a, 1110, 1210) is configured to apply a combination of a first bias ($U_0$, $U_{01}$, $U_{0a}$-$U_{0n}$, $U_B$) and a first signal portion depending on the input signal ($U_E$, $U_{Ea}$ - $U_{Ed}$, $U_{in}$, $U_{in1}$ - $U_{in3}$) as the first electrical signal ($U_S$, $U_{S1}$, $U_{Signal}$, $U_{signal1}$) to the first microelectromechanical transducer (141, 141a-b, 1016a) and/or a combination of a second bias ($U_0$, $U_{02}$, $U_{0a}$ - $U_{0n}$, $U_B$) and a second signal portion depending on the input signal ($U_E$, $U_{Ea}$ - $U_{Ed}$, $U_{in}$, $U_{in1}$ - $U_{in3}$) as the second electrical signal ($U_S$, $U_{S1}$, $U_{signal}$, $U_{signal1}$) to the second microelectromechanical transducer (142, 142a-b, 1016b).

4. Bending transducer (100, 100a-n, 300, 300a-n, 730a-n, 840, 840a-n) according to claim 3, wherein the first bias ($U_0$, $U_{01}$, $U_{0a}$ - $U_{0n}$, $U_B$) and/or the second bias ($U_0$, $U_{02}$, $U_{0a}$ - $U_{0n}$, $U_B$) is/are adjusted such that the centroid fiber (130,1 30a) of the deflectable element is not deflected without signal portions depending on the input signal ($U_E$, $U_{Ea}$ - $U_{Ed}$, $U_{in}$, $U_{in1}$ - $U_{in3}$) and without external mechanical influences on the deflectable element (110, 110a-n, 1120, 1220, 1300).

5. Bending transducer (100, 100a-n, 300, 300a-n, 730a-n, 840, 840a-n) according to Claim 3 or 4, wherein the electrical control (120, 1013a, 1110, 1210) is configured such that the spring stiffness of the bending transducer and/or the sensitivity of the bending transducer and/or the resonance frequency of the bending transducer are adjustable by adjusting the bias ($U_0$, $U_{01}$, $U_{02}$, $U_{0a}$ - $U_{0n}$, $U_B$) or the biases ($U_0$, $U_{01}$, $U_{02}$, $U_{0a}$ - $U_{0n}$, $U_B$) at the first and/or at the second microelectromechanical transducer (141, 141a-b, 142, 142a-b, 1016a, 1016b).

6. Bending transducer (100, 100a-n, 300, 300a-n, 730a-n, 840, 840a-n) according to any one of the preceding claims, wherein the electrical control (120, 1013a, 1110, 1210) is configured to perform the change of the first and second electrical signals ($U_S$, $U_{S1}$, $U_{S2}$, $U_{Signal}$, $U_{Signal1}$, $U_{Signal2}$) with differing amplitudes to compensate an asymmetrical load (1130, 1230) on the deflectable element (110, 110a-n, 1120, 1220, 1300).

7. Bending transducer (100, 100a-n, 300, 300a-n, 730a-n, 840, 840a-n) according to claim 6, wherein the electrical control (120, 1013a, 1110, 1210) is configured to perform the change of the first and second electrical signals ($U_S$, $U_{S1}$, $U_{S2}$, $U_{Signal}$, $U_{Signal1}$, $U_{Signal2}$) with differing amplitudes to compensate the asymmetrical load (1130, 1230), which is a structural asymmetry of the microelectromechanical transducer (141, 141a-b, 142, 142a-b, 1016a, 1016b) and/or an asymmetrical force acting on the deflectable element (110, 110a-n, 1120, 1220, 1300).

8. Bending transducer (100, 100a-n, 300, 300a-n, 730a-n, 840, 840a-n) according to claim 6 or 8, wherein the electrical control (120, 1013a, 1110, 1210) comprises a feedback loop (1240) for dynamically compensating the effect of the asymmetrical load (1130, 1230).

9. Bending transducer system (210, 410, 710, 910) comprising a plurality of bending transducers (100, 100a-n, 300, 300a-n, 730a-n, 840, 840a-n) according to any one of the preceding claims 1 to 8, wherein the plurality of bending transducers (100, 100a-n, 300, 300a-n, 730a-n, 840, 840a-n) match with respect to a dimensioning of the microelectromechanical transducers (141, 141a-b, 142, 142a-b, 1016a, 1016b), wherein the spring stiffnesses and/or the resonance frequencies and/or the sensitivities of the plurality of bending transducers (100, 100a-n, 300, 300a-n, 730an, 840a-n) are individually adjustable via a bias to the first and/or second microelectromechanical bending transducers (100, 100a-n, 300, 300a-n, 730a-n, 840, 840a-n).

10. Bending transducer system (210, 410, 710, 910) comprising a plurality of bending transducers (100, 100a-n, 300, 300a-n, 730a-n, 840, 840a-n) according to any one of the preceding claims 1 to 9 and a splitting circuit (220) configured to spectrally split a total input signal ($U_E$, $U_{in}$) into a plurality of input signals ($U_{Ea}$ - $U_{Ed}$, $U_{in1}$ - $U_{in3}$) for the plurality of bending transducers.

**Revendications**

1.  Transducteur de flexion comme actionneur (100, 100a-n, 730a-n), avec un élément pouvant être dévié (110, 110a-n, 1120, 1220, 1300), avec

    un premier transducteur micro-électromécanique (141, 141a-b, 1016a) s'étendant le long d'une fibre de centre de surface (130, 130a) de l'élément pouvant être dévié, qui, lors de l'application d'un premier signal électrique ($U_S$, $U_{S1}$, $U_{Signal}$, $U_{Signal1}$), dévie l'élément pouvant être dévié (110, 110a-n, 1120, 1220, 1300) dans une première direction (161, 161b), et
    un deuxième transducteur micro-électromécanique (142, 142a-b, 1016b) s'étendant le long de la fibre de centre de surface (130, 130a) de l'élément pouvant être dévié, qui, lors de l'application d'un deuxième signal électrique ($U_S$, $U_{S2}$, $U_{Signal}$, $U_{Signal2}$), dévie l'élément pouvant être dévié dans une deuxième direction (162, 162b) opposée à la première,

    dans lequel la fibre de centre de surface (130, 130a) définit un trajet que relie une pluralité de points qui résultent des centres de surface d'une pluralité de surfaces transversales successives de l'élément pouvant être dévié (110, 110a-n, 1120, 1220, 1300) de manière transversale à la direction longitudinale, et la fibre de centre de surface (130, 130a) est située entre les côtés opposés l'un à l'autre du premier et du deuxième transducteur micro-électromécanique (141, 141a-b, 142, 142a-b, 1016a, 1016b), et
    dans lequel la fibre de centre de surface (130, 130a) est située entre les côtés opposés l'un à l'autre du premier et du deuxième transducteur micro-électromécanique (141, 141a-b, 142, 142a-b, 1016a, 1016b), et

    un moyen de commande électrique (120, 1013a) qui est conçu pour faire varier le premier signal électrique ($U_S$, $U_{S1}$, $U_{Signal}$, $U_{Signal1}$) et le deuxième signal électrique ($U_S$, $U_{S2}$, $U_{Signal}$, $U_{Signal2}$) en fonction d'un signal d'entrée ($U_E$, $U_{Ea}$ à $U_{Ed}$, $U_{in}$, $U_{in1}$ à $U_{in3}$), de sorte qu'une variation du premier signal électrique ($U_S$, $U_{S1}$, $U_{Signal}$, $U_{Signal1}$) et une variation du deuxième signal électrique ($U_S$, $U_{S1}$, $U_{Signal}$, $U_{Signal2}$) soient fonction du signal d'entrée électrique ($U_E$, $U_{Ea}$ à $U_{Ed}$, $U_{in}$, $U_{in1}$ à $U_{in3}$), et que les phases du premier et du deuxième signal électrique ($U_S$, $U_{S1}$, $U_{S2}$, $U_{Signal}$, $U_{Signal1}$, $U_{Signal2}$) soient décalées l'une par rapport à l'autre,
    **caractérisé par le fait que**
    le premier convertisseur micro-électromécanique (141, 141a-b, 1016a) et le deuxième convertisseur micro-électromécanique (142, 142a-b, 1016b) présentent un condensateur à plaques (169) segmenté le long d'une direction longitudinale de l'élément pouvant être dévié.

2.  Transducteur de flexion (100, 100a-n, 300, 300a-n, 730a-n, 840, 840a-n) selon la revendication 1, dans lequel les électrodes (151 à 154, 151a à 154a) des premier et deuxième condensateurs à plaques sont réalisées de manière interdigitale.

3.  Transducteur de flexion (100, 100a-n, 300, 300a-n, 730a-n, 840, 840a-n) selon la revendication 1, dans lequel le moyen de commande électrique (120, 1013a, 1110, 1210) est conçu pour appliquer une combinaison d'une première précontrainte ($U_0$, $U_{01}$, $U_{0a}$ à $U_{0n}$, $U_B$) et d'une première part de signal qui dépend du signal d'entrée ($U_E$, $U_{Ea}$ à $U_{Ed}$, $U_{in}$, $U_{in1}$ à $U_{in3}$) comme premier signal électrique ($U_S$, $U_{S1}$, $U_{Signal}$, $U_{Signal1}$) au premier transducteur micro-électromécanique (141, 141a-b, 1016a) et/ou une combinaison d'une deuxième précontrainte ($U_0$, $U_{01}$, $U_{0a}$ à $U_{0n}$, $U_B$) et d'une deuxième part de signal qui dépend du signal d'entrée ($U_E$, $U_{Ea}$ à $U_{Ed}$, $U_{in}$, $U_{in1}$ à $U_{in3}$) comme deuxième signal électrique ($U_S$, $U_{S1}$, $U_{Signal}$, $U_{Signal1}$) au deuxième convertisseur micro-électromécanique (142, 142a-b, 1016b).

4.  Transducteur de flexion (100, 100a-n, 300, 300a-n, 730a-n, 840, 840a-n) selon la revendication 3, dans lequel la première précontrainte ($U_0$, $U_{01}$, $U_{0a}$ à $U_{0n}$, $U_B$) et/ou la deuxième précontrainte ($U_0$, $U_{02}$, $U_{0a}$ à $U_{0n}$, $U_B$) est ou sont réglées de sorte que la fibre de centre de surface (130, 130a) de l'élément pouvant être dévié ne soit pas déviée sans parts du signal d'entrée qui dépendent du signal d'entrée ($U_E$, $U_{Ea}$ à $U_{Ed}$, $U_{in}$, $U_{in1}$ à $U_{in3}$) et sans influences mécaniques externes sur l'élément pouvant être dévié (110, 110a-n, 1120, 1220, 1300).

5.  Transducteur de flexion (100, 100a-n, 300, 300a-n, 730a-n, 840, 840a-n) selon la revendication 3 ou 4, dans lequel le moyen de commande électrique (120, 1013a, 1110, 1210) est conçu de sorte que la résistance de ressort du transducteur de flexion et/ou la sensibilité du transducteur de flexion et/ou la fréquence de résonance du transducteur de flexion puisse être réglée en réglant la précontrainte ($U_0$, $U_{01}$, $U_{02}$, $U_{0a}$ à $U_{0n}$, $U_B$) ou les précontraintes ($U_0$, $U_{01}$, $U_{02}$, $U_{0a}$ à $U_{0n}$, $U_B$) sur le premier et/ou le deuxième transducteur micro-électromécanique (141, 141a-b, 142, 142a-b, 1016a, 1016b).

6. Transducteur de flexion (100, 100a-n, 300, 300a-n, 730a-n, 840, 840a-n) selon l'une des revendications précédentes, dans lequel le moyen de commande électrique (120, 1013a, 1110, 1210) est conçu pour effectuer la modification du premier et du deuxième signal électrique ($U_S$, $U_{S1}$, $U_{S2}$, $U_{Signal}$, $U_{Signal1}$, $U_{Signal2}$) avec des amplitudes différentes pour compenser une charge asymétrique (1130, 1230) sur l'élément pouvant être dévié (110, 110a-n, 1120, 1220, 1300).

7. Transducteur de flexion (100, 100a-n, 300, 300a-n, 730a-n, 840, 840a-n) selon la revendication 6, dans lequel le moyen de commande électrique (120, 1013a, 1110, 1210) est conçu pour effectuer la modification du premier et du deuxième signal électrique ($U_S$, $U_{S1}$, $U_{S2}$, $U_{Signal}$, $U_{Signal1}$, $U_{Signal2}$) avec une amplitude différente pour compenser la charge asymétrique (1130, 1230) qui est une asymétrie constructive du transducteur micro-électromécanique (141, 141a-b, 142, 142a-b, 1016a, 1016b) et/ou une force asymétrique qui agit sur l'élément pouvant être dévié (110, 110a-n, 1120, 1220, 1300).

8. Transducteur de flexion (100, 100a-n, 300, 300a-n, 730a-n, 840, 840a-n) selon la revendication 6 ou 8, dans lequel le moyen de commande électrique (120, 1013a, 1110, 1210) présente une boucle de rétroaction (1240) pour compenser de manière dynamique l'effet de la charge asymétrique (1130, 1230).

9. Système de transducteurs de flexion (210, 410, 710, 910) avec une pluralité de transducteurs de flexion (100, 100a-n, 300, 300a-n, 730a-n, 840, 840a-n) selon l'une des revendications précédentes 1 à 8, dans lequel la pluralité de transducteurs de flexion (100, 100an, 300, 300a-n, 730a-n, 840, 840a-n) coïncident en rapport avec un dimensionnement des transducteurs micro-électromécaniques (141, 141a-b, 142, 142a-b, 1016a, 1016b), dans lequel les résistances de ressort et/ou les fréquences de résonance et/ou les sensibilités de la pluralité de transducteurs de flexion (100, 100an, 300, 300a-n, 730a-n, 840, 840a-n) peuvent être réglées individuellement par l'intermédiaire d'une précontrainte sur le premier et/ou le deuxième transducteur de flexion micro-électromécanique (100, 100a-n, 300, 300a-n, 730a-n, 840, 840an).

10. Système de transducteurs de flexion (210, 410, 710, 910) avec une pluralité de transducteurs de flexion (100, 100a-n, 300, 300a-n, 730a-n, 840, 840a-n) selon l'une des revendications précédentes 1 à 9 et un circuit de division (220) qui est conçu pour diviser un signal d'entrée global ($U_E$, $U_{in}$) de manière spectrale sur une pluralité de signaux d'entrée ($U_{Ea}$ à $U_{Ed}$, $U_{in1}$ à $U_{in3}$) pour la pluralité de transducteurs de flexion.

Fig. 1
(Stand der Technik)

Fig. 2
(Stand der Technik)

Fig. 3
(Stand der Technik)

Fig. 4a

Fig. 4b
(Stand der Technik)

Fig. 5
(Stand der Technik)

auslenkbares Element
1300

Fig. 6

Fig. 7a

Fig. 7b

Schleife I

$U_{S1} = U_{01} + U_{signal\ 1}$ : Bimorph I

$U_{S2} = U_{02} - U_{signal\ 2}$ : Bimorph II

Schleife II

Fig. 8

Fig. 9

Fig. 10

EP 3 867 191 B1

| Ansteuerung: angepasste Symmetrie 1110 | auslenkbares Element mit angepasster Symmetrie 1120 | Last: asymmetrisch 1130 |

Symmetrisches Gesamtsystem 1100

## Fig. 11

| Ansteuerung: dynamisch angepasste Symmetrie 1210 | auslenkbares Element: dynamisch angepasste Symmetrie 1220 | Last: asymmetrisch 1230 |

Rückkopplung 1240

Symmetrisches Gesamtsystem mit Rückkopplungssystem 1200

## Fig. 12

$$U_{Ea} \quad U_{Eb} \quad U_{Ec} \quad U_{Ed}$$

240a  240b  240c  ···  240n

$$U_E$$

230

Fig. 13

410

300a

300b

300c

300n

$U_{aus,a}$    $U_{aus,b}$    $U_{aus,c}$    $U_{aus,n}$

440a    440b    440c    · · ·    440n

420

$U_{aus}$

430

Fig. 14

Fig. 15

Fig. 16

$U_{out1}$

$U_{in1}$

$U_{out2}$

$U_{in2}$

$U_{out3}$

$U_{in3}$

840a

910

840b

840n

910

S

920

Fig. 17

Fig. 18a

Fig. 18b

Fig. 18c

Fig. 18d

Fig. 19a

Fig. 19b

EP 3 867 191 B1

Fig. 19c

EP 3 867 191 B1

Fig. 20a

Fig. 20b

Fig. 20c

Fig. 21a

Fig. 21b

Fig. 22

EP 3 867 191 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9783408 B2
- WO 2095185 A1
- DE 102015206774 A1
- FR 2376549 A1
- WO 2012095185 A